# EUROPEAN PATENT APPLICATION

(11) **EP 4 848 486 A1**
(43) Date of publication of application: **02.12.2026**
(21) Application number: 25774728.7
(22) Date of filing: 14.03.2025
(51) Int. Cl.: H01R 12/78, H01R 12/85, H01R 13/629, H01R 13/639

(54) **ELECTRONIC DEVICE INCLUDING CONNECTOR**

(30) Priority: 19.03.2024 KR 20240037731; 30.04.2024 KR 20240057674
(71) Applicant: Samsung Electronics Co., Ltd., Suwon-si, Gyeonggi-do 16677 (KR)
(72) Inventor: MUN, Hanseok, Suwon-si, Gyeonggi-do 16677 (KR); BAE, Bumhee, Suwon-si, Gyeonggi-do 16677 (KR); LEE, Inha, Suwon-si, Gyeonggi-do 16677 (KR); JUNG, Waneui, Suwon-si, Gyeonggi-do 16677 (KR); HAN, Jaeryong, Suwon-si, Gyeonggi-do 16677 (KR)
(74) Representative: Gulde & Partner
(86) International application number: PCT/KR2025/003295
(87) International publication number: WO 2025/198255

(57) **Abstract**

An electronic device disclosed herein comprises: a flexible circuit board; a circuit board; and a connector disposed on the circuit board and configured to connect to or disconnect from an end portion of the flexible circuit board. The connector includes: a connector housing that has a cavity formed therein; a first terminal that extends from the circuit board into the cavity and is configured to apply a first pressure in a first direction via a first contact point thereof; and a second terminal that extends from the circuit board into the cavity and is configured to apply a second pressure in a second direction opposite to the first direction via a second contact point thereof. The first terminal and the second terminal may be configured such that the first contact point and the second contact point are in contact with a first surface and a second surface of the end portion, respectively, when the end portion of the flexible circuit board is connected to the connector.

## Description

### [Technical Field]

The disclosure relates to an electronic device including a connector.

### [Background Art]

A circuit board and a flexible circuit board may be electrically connected via a connector. The connector connecting the circuit board and the flexible circuit board may be a flexible printed circuit (FPC) connector.

The flexible circuit board may be horizontally fastened to the FPC connector disposed on the circuit board. The FPC connector may have a reduced size in a height direction of the connector compared to a board-to-board (B-to-B) connector. In addition, since the FPC connector is fastened to the flexible circuit board, the FPC connector may be advantageous in reducing the number of connectors compared to a B-to-B connector, which needs to include corresponding connectors for fastening.

The above-described information may be provided as related art for the purpose of assisting in understanding the disclosure. None of the foregoing might be asserted as prior art relevant to the disclosure or used for determination on prior art.

### [Disclosure of Invention]

### [Technical Solution]

An electronic device according to an embodiment of the disclosure may include a circuit board, a flexible circuit board, and a connector.

The connector according to an embodiment of the disclosure may be disposed on the circuit board and configured to be fastened to or separated from an end portion of the flexible circuit board.

In an embodiment, the connector may include a connector housing including a hollow portion formed therein, a first terminal extending from the circuit board to the hollow portion and configured to apply a first pressure in a first direction via a first contact point thereof, and a second terminal extending from the circuit board to the hollow portion and configured to apply a second pressure in a second direction opposite to the first direction via a second contact point thereof.

In an embodiment, the first terminal and the second terminal may be configured such that, when the end portion of the flexible circuit board is fastened to the connector, the first contact point and the second contact point come into contact with a first surface and a second surface of the end portion, respectively.

In an embodiment, the flexible circuit board may be electrically connected to the circuit board.

In an embodiment, the connector may be disposed on the circuit board and may be coupled to the flexible circuit board.

In an embodiment, the connector may include a plurality of first terminals, a plurality of second terminals, and the connector housing.

In an embodiment, the plurality of first terminals may be disposed to be spaced apart from each other in a length direction of the connector and may include first contact points.

In an embodiment, the plurality of second terminals may be disposed to be aligned with the plurality of first terminals, may at least partially face the plurality of first terminals, and may include second contact points.

In an embodiment, the plurality of first terminals and the plurality of second terminals may be disposed in the connector housing.

In an embodiment, the first contact points may come into contact with a portion of the first surface of the flexible circuit board, and the second contact points may come into contact with a portion of a second surface opposite to the first surface of the flexible circuit board. In an embodiment, a first pressure directed toward the flexible circuit board at the first contact points may be greater than a second pressure directed toward the flexible circuit board at the second contact points.

In an embodiment, the connector housing may include engagement portions located at opposite ends of the connector housing with respect to a length direction of the connector and formed to protrude in a height direction of the connector.

In an embodiment, the connector housing may include a stopper for preventing the flexible circuit board from being inserted into the connector to a predetermined length or more.

In an embodiment, the plurality of first terminals and the plurality of second terminals may be coupled to at least a portion of the connector housing in a fitted manner.

### [Brief Description of Drawings]

With regard to the description of the drawings, the same or like reference signs may be used to designate the same or like elements.
FIG. 1 is a block diagram of an electronic device in a network environment according to an embodiment.
FIG. 2 is a view illustrating an electronic device according to an embodiment of the disclosure.
FIGS. 3A and 3B are views illustrating a connector according to an embodiment of the disclosure.
FIG. 4 is a view illustrating a connector and a flexible circuit board according to an embodiment of the disclosure.
FIG. 5 is a view illustrating a flexible circuit board according to an embodiment of the disclosure.
FIG. 6 is a view illustrating a process in which a flexible circuit board according to an embodiment of the disclosure is inserted into a connector.
FIG. 7 is a view illustrating a connector and a flexible circuit board according to an embodiment of the disclosure.
FIG. 8 is a view illustrating a connector and a flexible circuit board according to an embodiment of the disclosure.
FIGS. 9A and 9B are views illustrating an operation of separating a connector and a flexible circuit board according to an embodiment of the disclosure.
FIG. 10 is a view illustrating movement of a first terminal and a second terminal according to an embodiment of the disclosure.
FIGS. 11A and 11B are views illustrating a stopper of a connector according to an embodiment of the disclosure.
FIGS. 12A and 12B are exploded perspective views of a connector according to an embodiment of the disclosure.
FIGS. 13A and 13B are views illustrating first terminals according to an embodiment of the disclosure.
FIGS. 14A and 14B are views illustrating second terminals according to an embodiment of the disclosure.
FIGS. 15A and 15B are views illustrating a pitch between first terminals.
FIG. 16 is a view illustrating a connector according to an embodiment of the disclosure.
FIG. 17 is a view illustrating a connector and a flexible circuit board according to an embodiment of the disclosure.

### [Mode for the Invention]

Hereinafter, embodiments of the disclosure will be described in detail with reference to the accompanying drawings so that those skilled in the art may easily implement the embodiments. However, the disclosure may be embodied in various forms, and thus is not limited to the embodiments described herein. In connection with the description of the drawings, the same or similar reference numerals may be used for the same or similar elements. Moreover, a description of well-known functions and configurations may be omitted for the sake of clarity and conciseness in the drawings and related descriptions.

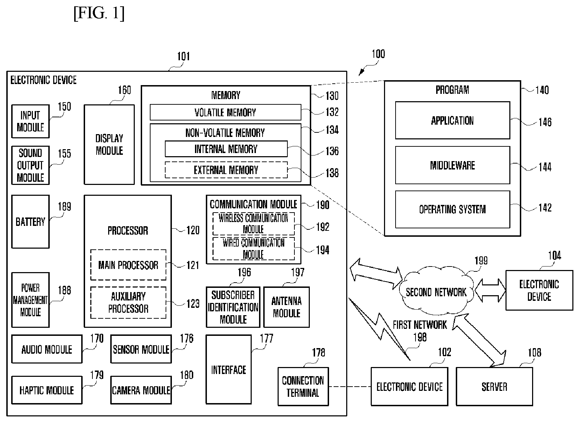

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

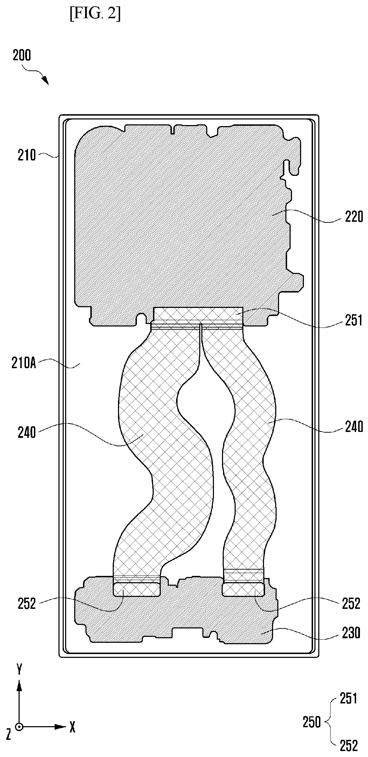

FIG. 2 is a view illustrating an electronic device 200 according to an embodiment of the disclosure.

For example, various embodiments described below merely present specific components to easily explain the technical features of the disclosure and to help understanding of the disclosure, and are not intended to limit the scope of the disclosure.

Accordingly, the scope of the disclosure should be construed as including all changes or modifications derived based on the technical spirit of the disclosure, in addition to the embodiments disclosed herein.

In an embodiment, the electronic device 200 may refer to the electronic device 101 illustrated in FIG. 1 or may include at least some of the components of the electronic device 101 illustrated in FIG. 1.

In describing the electronic device 200 according to an embodiment of the disclosure, a width direction of the electronic device 200 may refer to an X-axis direction, and a length direction of the electronic device 200 may refer to a Y-axis direction. A height direction of the electronic device 200 may refer to a Z-axis direction perpendicular to the width direction and the length direction.

The electronic device 200 according to an embodiment of the disclosure may include a housing 210, a first circuit board 220, a second circuit board 230, a flexible circuit board 240, and/or a connector 250.

In an embodiment, the housing 210 may form an exterior of the electronic device 200. In an embodiment, at least some of the components of the electronic device 200 may be disposed in the housing 210. For example, referring to FIG. 2, the first circuit board 220 and the second circuit board 230 may be disposed on one surface 210A of the housing 210.

In an embodiment, the first circuit board 220 may be disposed to be spaced apart from the second circuit board 230. For example, referring to FIG. 2, the first circuit board 220 may be disposed to be spaced apart from the second circuit board 230 in the length direction of the electronic device 200 (e.g., the Y-axis direction).

In an embodiment, the flexible circuit board 240 may electrically connect the first circuit board 220 and the second circuit board 230. At least a portion of the flexible circuit board 240 may extend between the first circuit board 220 and the second circuit board 230.

In an embodiment, the first circuit board 220 and the second circuit board 230 may be electrically connected to each other via the flexible circuit board 240. For example, referring to FIG. 2, the first circuit board 220 and the second circuit board 230 may be electrically connected to each other via two flexible circuit boards 240.

In an embodiment, the connector 250 may include a first connector 251 and/or a second connector 252.

In an embodiment, the connector 250 may be a flexible printed circuit (FPC) connector to which the flexible circuit board 240 is coupled.

In an embodiment, the connector 250 may be coupled to at least one flexible circuit board 240.

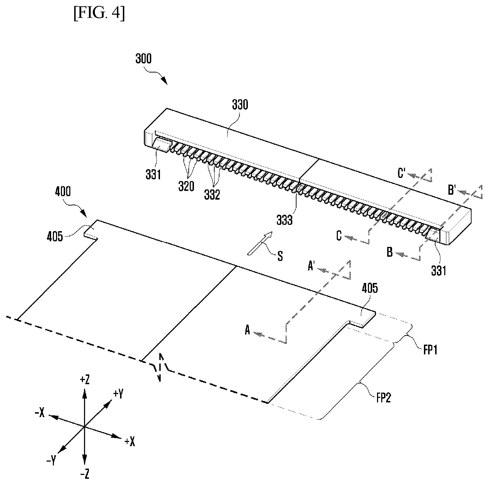

In an embodiment, the connector 250 may be disposed on the circuit board 220 or 230 and may be configured to be fastened to or separated from an end portion FP1 of the flexible circuit board 240 (see FIG. 4).

In an embodiment, two or more flexible circuit boards 240 may be coupled to a single connector 250. For example, referring to FIG. 2, two flexible circuit boards 240 may be coupled to a single first connector 251.

In an embodiment, a single connector 250 may be coupled to a single flexible circuit board 240. For example, referring to FIG. 2, two second connectors 252 may each be coupled to one flexible circuit board 240.

In an embodiment, the first connector 251 may be disposed on the first circuit board 220. The second connectors 252 may be disposed on the second circuit board 230.

In an embodiment, the flexible circuit boards 240 may be coupled to the connectors 250. For example, the flexible circuit boards 240 may be coupled to the first connector 251 at respective one end portions and may be coupled to the second connectors 252 at the other end portions opposite to the one end portions.

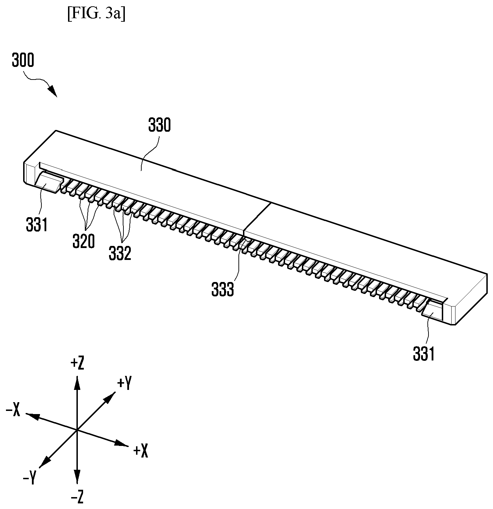

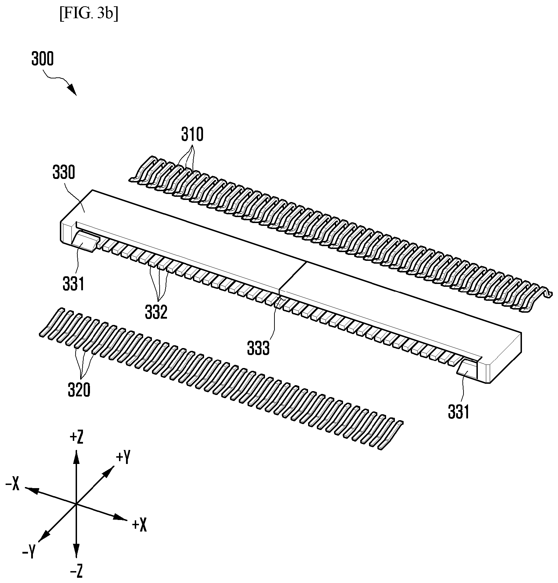

FIGS. 3A and 3B are views illustrating a connector 300 according to an embodiment of the disclosure.

FIG. 3A is a view illustrating the connector 300 according to an embodiment. FIG. 3B is an exploded perspective view of the connector 300 according to an embodiment.

In an embodiment, the connector 300 may refer to the connector 250 illustrated in FIG. 2 or may include at least a portion of the connector 250 illustrated in FIG. 2.

In describing the connector 300 according to an embodiment of the disclosure, a length direction of the connector 300 may refer to the X-axis direction, and a width direction of the connector 300 may refer to the Y-axis direction. A height direction of the connector 300 may refer to a Z-axis direction.

The connector 300 according to an embodiment of the disclosure may include a first terminal 310, a second terminal 320, and/or a connector housing 330.

In an embodiment, the connector 300 may include a plurality of first terminals 310. The plurality of first terminals 310 may be disposed to be spaced apart from each other in the length direction of the connector 300 (e.g., the X-axis direction).

In an embodiment, the connector 300 may include a plurality of second terminals 320. The plurality of second terminals 320 may be disposed to be spaced apart from each other in the length direction of the connector 300.

In an embodiment, at least one of the plurality of second terminals 320 may be aligned with a corresponding one of the plurality of first terminals 310.

In an embodiment, the second terminals 320 may be disposed to be aligned with the first terminals 310.

In an embodiment, the second terminals 320 may be disposed to at least partially face the first terminals 310.

In an embodiment, the connector 300 may be formed of a resin material. For example, the connector 300 may be formed of a resin material based on liquid crystal polymer (LCP) and/or nylon (e.g., nylon polyamide (PA) 6), which has high heat resistance and high strength.

In an embodiment, the connector 300 may be formed by an injection method. For example, the connector 300 may be molded by injection-molding a resin material.

In an embodiment, the first terminal 310 and the second terminal 320 may include a metal material. For example, the first terminal 310 and the second terminal 320 may include a copper alloy.

In an embodiment, the first terminal 310 and the second terminal 320 may include a Corson alloy having high electrical conductivity and high strength.

In an embodiment, the first terminal 310 and the second terminal 320 may be formed by processing a metal material through a bending and/or notching process.

In an embodiment, the first terminals 310 and the second terminals 320 may be disposed in the connector housing 330.

In an embodiment, the connector housing 330 may include engagement portions 331, support portions 332, and/or a housing opening 333.

In an embodiment, the engagement portions 331 may serve to prevent or reduce separation of the flexible circuit board 400 fastened to the connector 300 from the connector 300 (see FIG. 4).

In an embodiment, the plurality of support portions 332 may be disposed to be spaced apart from each other in the length direction of the connector housing 330 (e.g., the X-axis direction).

In an embodiment, the length direction of the connector housing 330 may refer to a direction in which the connector housing 330 extends relatively long in a rectangular shape of the connector housing 330 (e.g., the X-axis direction). In an embodiment, the width direction of the connector housing 330 may refer to a direction in which the connector housing 330 extends relatively short in the rectangular shape of the connector housing 330 (e.g., the Y-axis direction).

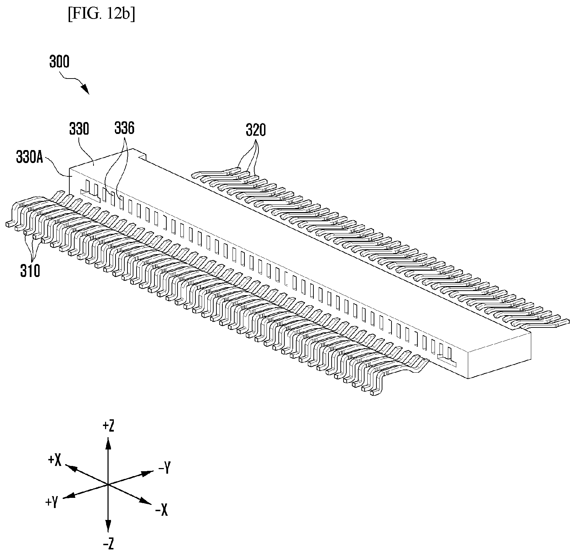

In an embodiment, the first terminals 310 may be disposed in a manner of being fitted into at least a portion of the connector housing 330. For example, the first terminals 310 may be disposed in a manner of being fitted into openings 336 formed in a sidewall 330A of the connector housing 330 (see FIG. 12B).

In an embodiment, the second terminals 320 may each be disposed in the connector housing 330 in a manner of being fitted between two support portions 332.

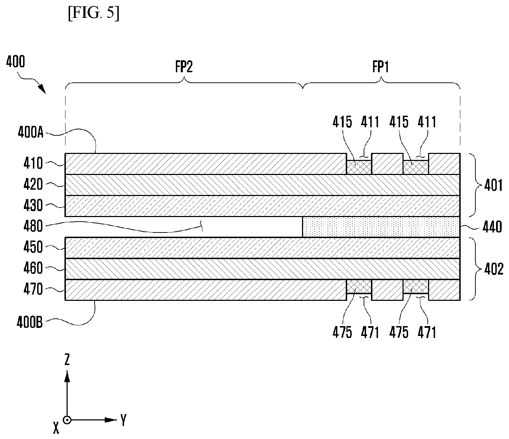

FIG. 4 is a view illustrating a connector 300 and a flexible circuit board 400 according to an embodiment of the disclosure. FIG. 5 is a view illustrating the flexible circuit board 400 according to an embodiment of the disclosure.

In an embodiment, the flexible circuit board 400 may refer to the flexible circuit board 240 illustrated in FIG. 2 or may include at least a portion of the flexible circuit board 240 illustrated in FIG. 2.

In an embodiment, the flexible circuit board 400 may include protrusions 405 at opposite ends thereof. In an embodiment, the protrusions 405 may include at least partial regions of opposite ends of the flexible circuit board 400 (e.g., the end portions of the flexible circuit board 400 in the X-axis direction) that extend further than other regions.

In an embodiment, when the flexible circuit board 400 is fastened to the connector 300, the protrusions 405 of the flexible circuit board 400 may face the engagement portions 331 of the connector 300.

Referring to FIGS. 4 and 5, the flexible circuit board 400 may include an end portion FP1 and/or a flexible portion FP2.

In an embodiment, the end portion FP1 of the flexible circuit board 400 may be a portion located at an end of the flexible circuit board 400. In an embodiment, the end portion FP1 may be a portion of the flexible circuit board 400 that is coupled to the connector 300.

In an embodiment, the flexible portion FP2 of the flexible circuit board 400 may be a region formed such that the flexible circuit board 400 is bendable.

In an embodiment, at least a portion of the connector 300 may come into contact with at least a portion of the end portion FP1 of the flexible circuit board 400. In an embodiment, plating layers (e.g., pads), which come into contact with the first terminals 310 and the second terminals 320 of the connector 300 (see FIG. 3B), may be formed on at least a portion of the end portion FP1 of the flexible circuit board 400. The first terminals 310 and the second terminals 320 of the connector 300 (see FIG. 3B) may come into contact with plating layers (e.g., pads) formed on the end portion FP1 of the flexible circuit board 400 and may be electrically connected to the flexible circuit board 400.

Referring to FIG. 4, the flexible circuit board 400 may be moved in a direction S toward the connector 300, and at least a portion thereof may be inserted into the connector 300. For example, the end portion FP1 of the flexible circuit board 400 may be inserted into the connector 300 through the housing opening 333 of the connector 300. The flexible circuit board 400 inserted into the connector 300 may come into contact with the first terminals 310 and the second terminals 320 (see FIG. 3B).

In an embodiment, at least a portion of the flexible circuit board 400 may be inserted into the connector 300.

FIG. 5 is a view illustrating the flexible circuit board 400 as viewed along line A-A' of FIG. 4.

Referring to FIG. 5, the flexible circuit board 400 according to an embodiment of the disclosure may include a first laminated structure 401, a second laminated structure 402, and/or an insulating adhesive layer 440.

In an embodiment, the first laminated structure 401 may include a first insulating cover layer 410, a first conductive layer 420, a first resin layer 430, and/or a first plating layer 415.

In an embodiment, the second laminated structure 402 may include a second insulating cover 470, a second conductive layer 460, a second resin layer 450, and/or a second plating layer 475.

In an embodiment, the first laminated structure 401 and the second laminated structure 402 may be coupled to each other at least in part via the insulating adhesive layer 440. For example, the first laminated structure 401 may be coupled to one surface of the insulating adhesive layer 440, and the second laminated structure 402 may be coupled to the other surface of the insulating adhesive layer 440.

In an embodiment, the first insulating cover layer 410 may form at least a portion of a first surface 400A of the flexible circuit board 400. In an embodiment, the first insulating cover layer 410 may include first opening regions 411 formed therein.

In an embodiment, the second insulating cover layer 470 may form at least a portion of a second surface 400B of the flexible circuit board 400. In an embodiment, the second insulating cover layer 470 may include second opening regions 471 formed therein.

In an embodiment, the first conductive layer 420 and the second conductive layer 460 may be layers including a metal material (e.g., copper).

In an embodiment, the first conductive layer 420 may be disposed on the first insulating cover layer 410. For example, referring to FIG. 5, the first conductive layer 420 may be disposed in the negative Z-axis direction with respect to the first insulating cover layer 410.

In an embodiment, the second conductive layer 460 may be disposed on the second insulating cover layer 470. For example, referring to FIG. 5, the second conductive layer 460 may be disposed in the positive Z-axis direction with respect to the second insulating cover layer 470.

In an embodiment, the first resin layer 430 and the second resin layer 450 may include an insulating material. For example, the first resin layer 430 and the second resin layer 450 may include polyimide.

In an embodiment, the first plating layer 415 may be disposed to at least partially fill the first opening regions 411. In an embodiment, the first plating layer 415 may be a plating layer formed of a conductor (e.g., gold).

In an embodiment, the first plating layer 415 may be disposed on the first conductive layer 420. For example, the first plating layer 415 may be disposed above the first conductive layer 420 (e.g., in the positive Z-axis direction with respect to the first conductive layer 420).

In an embodiment, the second plating layer 475 may be disposed to at least partially fill the second opening regions 471. In an embodiment, the second plating layer 475 may be a plating layer formed of a conductor (e.g., gold).

In an embodiment, the second plating layer 475 may be disposed on the second conductive layer 460. For example, the second plating layer 475 may be disposed below the second conductive layer 460 (e.g., in the negative Z-axis direction with respect to the second conductive layer 460).

In an embodiment, the insulating adhesive layer 440 may be disposed on at least a portion between the first conductive layer 420 and the second conductive layer 460. The insulating adhesive layer 440 may serve to connect the first conductive layer 420 and the second conductive layer 460.

In an embodiment, the insulating adhesive layer 440 may serve to reinforce strength of the flexible circuit board 400. In an embodiment, the insulating adhesive layer 440 may include prepreg.

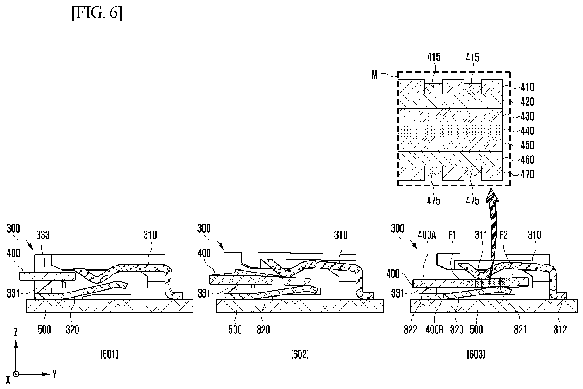

In an embodiment, the flexible circuit board 400 may include the insulating adhesive layer 440, thereby having reinforced strength. For example, the flexible circuit board 400 may include the insulating adhesive layer 440, thereby having strength equal to or greater than a predetermined standard. In an embodiment, since the flexible circuit board 400 includes the insulating adhesive layer 440, damage to the flexible circuit board 400 may be prevented or reduced even when the flexible circuit board 400 comes into contact with the engagement portions 331 of the connector housing 330 in a process of being inserted into the connector 300 (see FIG. 6). In an embodiment, since the flexible circuit board 400 includes the insulating adhesive layer 440, the flexible circuit board 400 may be able to withstand a force applied by the engagement portions 331 of the connector housing 330 in a process of being separated again after being inserted into the connector 300.

In an embodiment, the insulating adhesive layer 440 of the flexible circuit board 400 may be formed to be thicker than other layers of the flexible circuit board 400.

In an embodiment, the insulating adhesive layer 440 may have a thickness greater than that of each of the first conductive layer 420 and the second conductive layer 460. For example, in an embodiment, the thickness of the insulating adhesive layer 440 may be about 40 µm to 60 µm. The thicknesses of the first conductive layer 420 and the second conductive layer 460 may each be about 7 µm to 17 µm.

In an embodiment, the thickness of the first plating layer 415 may be about 5 µm to 15 µm. The thickness of the first conductive layer 420 may be about 7 µm to 17 µm. The thickness of the first resin layer 430 may be about 7 µm to 17 µm.

In an embodiment, the thickness of the second plating layer 475 may be about 5 µm to 15 µm. The thickness of the second conductive layer 460 may be about 7 µm to 17 µm. The thickness of the second resin layer 450 may be about 7 µm to 17 µm.

In an embodiment, when the flexible circuit board 400 is fastened to the connector 300, the first conductive layer 420 may be electrically connected to a first contact point 311 of the connector 300 (see FIG. 6) through a first opening region 411. For example, a first plating layer 415 formed in the first opening region 411 may come into contact with the first contact point 311 (see FIG. 6), so that the first conductive layer 420 may be electrically connected to the first contact point 311 (see FIG. 6).

In an embodiment, when the flexible circuit board 400 is fastened to the connector 300, the second conductive layer 460 may be electrically connected to a second contact point 321 of the connector 300 (see FIG. 6) through a second opening region 471. For example, a second plating layer 475 formed in the second opening region 471 may come into contact with the second contact point 321 (see FIG. 6), so that the second conductive layer 460 may be electrically connected to the second contact point 321 (see FIG. 6).

In an embodiment, the flexible circuit board 400 may include a first conductive plating layer (not illustrated) formed on the first insulating cover layer 410. For example, the first conductive plating layer (not illustrated) may be a layer formed on a portion of the first insulating cover layer 410 and connected to the first plating layer 415 and/or the first conductive layer 420. When the flexible circuit board 400 is fastened to the connector 300 (see FIG. 6), the first conductive plating layer (not illustrated) may come into contact with a first contact point 311 (see FIG. 6), so that the first conductive layer 420 may be electrically connected to the first contact point 311 (see FIG. 6).

In an embodiment, the flexible circuit board 400 may include a second conductive plating layer (not illustrated) formed on the second insulating cover layer 470. For example, the second conductive plating layer (not illustrated) may be a layer formed on a portion of the second insulating cover layer 470 and connected to the second plating layer 475 and/or the second conductive layer 460. When the flexible circuit board 400 is fastened to the connector 300 (see FIG. 6), the second conductive plating layer (not illustrated) may come into contact with a second contact point 321 (see FIG. 6), so that the second conductive layer 460 may be electrically connected to the second contact point 321 (see FIG. 6).

In an embodiment, the insulating adhesive layer 440 may be formed in the end portion FP1 of the flexible circuit board 400. For example, the end portion FP1 of the flexible circuit board 400 may include the insulating adhesive layer 440 disposed between the first conductive layer 420 and the second conductive layer 460.

In an embodiment, the flexible portion FP2 of the flexible circuit board 400 may be a region formed such that the flexible circuit board 400 is bendable.

In an embodiment, the flexible portion FP2 of the flexible circuit board 400 may include a separation space 480 in at least a portion thereof. For example, the separation space 480 may be formed between the first resin layer 430 and the second resin layer 450.

FIG. 6 is a view illustrating a process in which a flexible circuit board 400 according to an embodiment is inserted into a connector 300.

FIG. 6 may be a view illustrating the flexible circuit board 400 and the connector 300 as viewed along line B-B' of FIG. 4.

A circuit board 500 of FIG. 6 may refer to the circuit board 220 or 230 illustrated in FIG. 2 or may include at least a portion of the circuit board 220 or 230 illustrated in FIG. 2.

Referring to FIG. 6, the connector 300 may be disposed on the circuit board 500.

Region M of FIG. 6 may be an enlarged view illustrating a portion of the flexible circuit board 400 that comes into contact with the first terminal 310 and the second terminal 320. Referring to region M of FIG. 6, the flexible circuit board 400 may include a first insulating cover layer 410, a first conductive layer 420, a first resin layer 430, a first plating layer 415, a second insulating cover layer 470, a second conductive layer 460, a second resin layer 450, a second plating layer 475, and/or an insulating adhesive layer 440. The flexible circuit board 400 may come into contact with the first terminal 310 at the first plating layer 415 and may come into contact with the second terminal 320 at the second plating layer 475.

Referring to FIG. 6, a first state (601) may be a state in which the flexible circuit board 400 starts to be inserted into the connector 300. For example, the first state (601) may be a state in which the flexible circuit board 400 is inserted into the connector 300, and the plating layers 415 and 475 of the flexible circuit board 400 do not come into contact with the first terminal 310 and the second terminal 320.

In the first state (601), the flexible circuit board 400 may be inserted into the connector 300 through a housing opening 333. In the first state (601), the flexible circuit board 400 may be inserted into the connector 300 without being caught by an engagement portion 331 of the connector housing 330. For example, in the first state

(601), the flexible circuit board 400 may be inserted into the connector 300 through the housing opening 333 while an end portion FP1 (see FIG. 4) is located in the positive Z-axis direction with respect to the engagement portion 331.

Referring to FIG. 6, a second state (602) may be a state in which the flexible circuit board 400 is moved between the first terminal 310 and the second terminal 320. In the second state (602), the flexible circuit board 400 may be moved in a direction toward the inside of the connector 300 (e.g., in the positive Y-axis direction).

In the second state (602), the flexible circuit board 400 may move and come into at least partial contact with the first terminal 310 and the second terminal 320. The flexible circuit board 400 may be moved and may push at least a portion of the first terminal 310 and at least a portion of the second terminal 320 in a height direction of the connector 300 (e.g., in the Z-axis direction). For example, the flexible circuit board 400 may push at least a portion of the first terminal 310 in the positive Z-axis direction and push at least a portion of the second terminal 320 in the negative Z-axis direction.

Referring to FIG. 6, a third state (603) may be a state in which the flexible circuit board 400 is completely inserted into the connector 300. For example, the third state (603) may be a state in which the flexible circuit board 400 is inserted into the connector 300 by a predetermined length and the flexible circuit board 400 is fastened to the connector 300.

In the third state (603), the first plating layer 415 of the flexible circuit board 400 may at least partially come into contact with the first terminal 310 on the first surface 400A. The second plating layer 475 of the flexible circuit board 400 may at least partially come into contact with the second terminal 320 on the second surface 400B opposite to the first surface 400A.

In an embodiment, the first terminal 310 may include a first contact point 311. In the third state (603), the first terminal 310 may at least partially come into contact with the first plating layer 415 of the flexible circuit board 400 at the first contact point 311.

In an embodiment, the second terminal 320 may include a second contact point 321. In the third state (603), the second terminal 320 may at least partially come into contact with the second plating layer 475 of the flexible circuit board 400 at the second contact point 321.

Referring to FIG. 6, in the third state (603), a first pressure F1 directed toward the flexible circuit board 400 at the first contact point 311 may be applied to the flexible circuit board 400. A second pressure F2 directed toward the flexible circuit board 400 at the second contact point 321 may be applied to the flexible circuit board 400.

In an embodiment, the first pressure F1 may be greater than the second pressure F2. Since the first pressure F1 is formed to be greater than the second pressure F2, the flexible circuit board 400 may receive a force in a direction toward the circuit board 500 (e.g., in the negative Z-axis direction). Since the first pressure F1 is formed to be greater than the second pressure F2, separation of the flexible circuit board 400 in a direction away from the circuit board 500 may be prevented or reduced in a state in which the flexible circuit board 400 is fastened to the connector 300.

In an embodiment, the first terminal 310 and the second terminal 320 may be electrically connected to the plating layers 415 and 475 of the circuit board 500. For example, the first terminal 310 may at least partially come into contact with the circuit board 500 at a first end portion 312 and may be electrically connected to the circuit board 500. The second terminal 320 may at least partially come into contact with the circuit board 500 at a second end portion 322 and may be electrically connected to the circuit board 500.

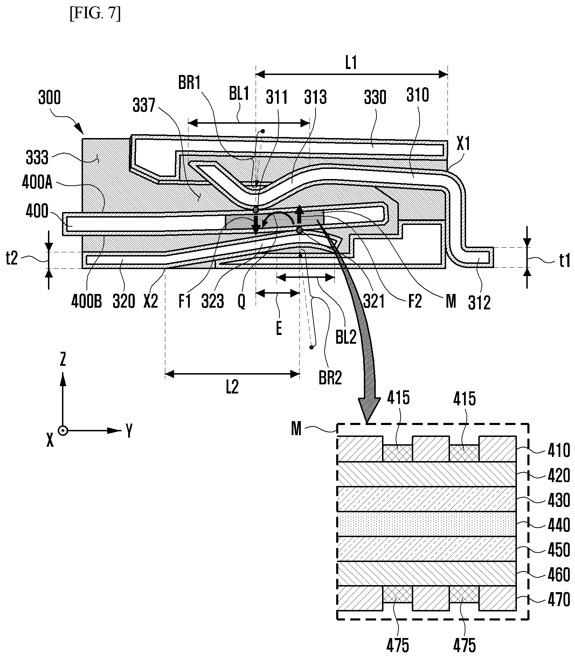

FIG. 7 is a view illustrating a connector 300 and a flexible circuit board 400 according to an embodiment of the disclosure.

FIG. 7 is a view illustrating a state in which the flexible circuit board 400 is fastened to the connector 300. For example, FIG. 7 may be a view illustrating a state in which the flexible circuit board 400 is fastened to the connector 300 as viewed along line C-C' of FIG. 4.

Region M of FIG. 7 may be an enlarged view illustrating a portion of the flexible circuit board 400 that comes into contact with the first terminal 310 and the second terminal 320. Referring to region M of FIG. 7, the flexible circuit board 400 may include a first insulating cover layer 410, a first conductive layer 420, a first resin layer 430, a first plating layer 415, a second insulating cover layer 470, a second conductive layer 460, a second resin layer 450, a second plating layer 475, and/or an insulating adhesive layer 440. The flexible circuit board 400 may come into contact with the first terminal 310 at the first plating layer 415 and may come into contact with the second terminal 320 at the second plating layer 475.

Referring to FIG. 7, a connector housing 330 may include a hollow portion 337 formed therein.

In an embodiment, the first terminal 310 may extend from a circuit board 500 (see FIG. 6) to the hollow portion 337. In an embodiment, the second terminal 320 may extend from the circuit board 500 (see FIG. 6) to the hollow portion 337.

Referring to FIG. 7, in a state in which the flexible circuit board 400 is fastened to the connector 300, the plating layers 415 and 475 of the flexible circuit board 400 may at least partially come into contact with the first terminal 310 and the second terminal 320.

FIG. 7 may be a view illustrating a state in which an end portion FP1 (see FIG. 5) of the flexible circuit board 400 is fastened to the connector 300.

In an embodiment, the end portion FP1 (see FIG. 5) of the flexible circuit board 400 may be inserted into the hollow portion 337 through a housing opening 333.

Referring to FIG. 7, when the end portion FP1 (see FIG. 5) of the flexible circuit board 400 is fastened to the connector 300, a first contact point 311 and a second contact point 321 may be configured to come into contact with a first surface 400A and a second surface 400B of the end portion FP1 of the flexible circuit board 400, respectively.

In an embodiment, the first plating layer 415 of the flexible circuit board 400 may at least partially come into contact with the first terminal 310 on the first surface 400A. The second plating layer 475 of the flexible circuit board 400 may at least partially come into contact with the second terminal 320 on the second surface 400B opposite to the first surface 400A.

In an embodiment, the plating layers 415 and 475 of the flexible circuit board 400 may at least partially come into contact with the first terminal 310 and the second terminal 320 and may be electrically connected thereto.

In an embodiment, the first terminal 310 may include a first contact point 311. The first terminal 310 may at least partially come into contact with the first plating layer 415 of the flexible circuit board 400 at the first contact point 311.

In an embodiment, the first terminal 310 may include a first bending region 313 bent convexly in a direction toward the flexible circuit board 400. Referring to FIG. 7, the first bending region 313 may be bent convexly in a first direction (e.g., in the negative Z-axis direction), and may include the first contact point 311.

In an embodiment, the first contact point 311 may be formed in the first bending region 313.

In an embodiment, the second terminal 320 may include a second contact point 321. The second terminal 320 may at least partially come into contact with the second plating layer 475 of the flexible circuit board 400 at the second contact point 321.

In an embodiment, the second terminal 320 may include a second bending region 323 bent convexly in a direction toward the flexible circuit board 400. For example, referring to FIG. 7, the second bending region 323 may be bent convexly in a second direction (e.g., in the positive Z-axis direction), and may include the second contact point 321.

In an embodiment, the second contact point 321 may be formed in the second bending region 323.

In an embodiment, the length of the first bending region 313 may refer to a length by which the first bending region 313 extends in the Y-axis direction. The length of the first bending region 313 may be a first length BL1.

In an embodiment, the length of the second bending region 323 may refer to a length by which the second bending region 323 extends in the Y-axis direction. The length of the second bending region 323 may be a second length BL2.

In an embodiment, the length of the first bending region 313 may be greater than the length of the second bending region 323. For example, the first length BL1 may be greater than the second length BL2.

In an embodiment, a first bending radius BR1 of the first bending region 313 may refer to the radius of curvature of the first bending region 313.

In an embodiment, a second bending radius BR2 of the second bending region 323 may refer to the radius of curvature of the second bending region 323.

In an embodiment, the first bending region 313 may be bent to a greater degree than the second bending region 323. For example, in an embodiment, the first bending radius BR1 may be smaller than the second bending radius BR2. Since the first bending radius BR1 of the first bending region 313 is smaller than the second bending radius BR2 of the second bending region 323, the first bending region 313 may be bent to a greater degree than the second bending region 323.

In an embodiment, a first movable distance L1 may be a distance from a fixed portion X1 of the first terminal 310 to the first contact point 311. A second movable distance L2 may be a distance from a fixed portion X2 of the second terminal 320 to the second contact point 321.

In an embodiment, the first movable distance L1 and the second movable distance L2 may be formed to be different from each other. In an embodiment, the first movable distance L1 and the second movable distance L2 may be formed to be different from each other, so that the first pressure F1 and the second pressure F2 may be different from each other.

Although FIG. 7 illustrates that the first movable distance L1 is longer than the second movable distance L2, the relationship between the first movable distance L1 and the second movable distance L2 is not limited thereto, and the connector 300 according to an embodiment may be formed such that the first movable distance L1 is shorter than or equal to the second movable distance L2.

In an embodiment, the first terminal 310 may have a first thickness t1. The second terminal 320 may have a second thickness t2. In an embodiment, the thicknesses t1 and t2 of the terminals 310 and 320 may each be a length by which the terminals 310 and 320 extend in the height direction of the connector 300 (e.g., the Z-axis direction).

In an embodiment, the first thickness t1 may be different from the second thickness t2. For example, the first thickness t1 may be greater than the second thickness t2.

Although FIG. 7 illustrates that the first thickness t1 is greater than the second thickness t2, the relationship between the first thickness t1 and the second thickness t2 is not limited thereto. The connector 300 according to an embodiment may be formed such that the first thickness t1 is smaller than or equal to the second thickness t2.

Referring to FIG. 7, in a state in which the flexible circuit board 400 is fastened to the connector 300, the first pressure F1 and the second pressure F2 may be applied to the flexible circuit board 400. The first pressure F1 may be applied to the flexible circuit board 400 in the first direction (e.g., the negative Z-axis direction) at the first contact point 311. The second pressure F2 may be applied to the flexible circuit board 400 in the second direction (e.g., the positive Z-axis direction) at the second contact point 321.

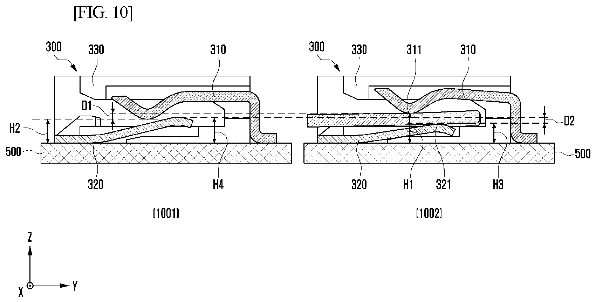

In an embodiment, magnitudes of the first pressure F1 and the second pressure F2 may vary based on thicknesses t1 and t2 of the terminals 310 and 320, deformation amounts D1 and D2 of the terminals 310 and 320 (see FIG. 10), and/or movable distances L1 and L2. For example, in an embodiment, since the first thickness t1 is greater than the second thickness t2, the first pressure F1 may be formed to be greater than the second pressure F2. In an embodiment, since a first deformation amount D1 (see FIG. 10) is greater than a second deformation amount D2 (see FIG. 10), the first pressure F1 may be formed to be greater than the second pressure F2.

In an embodiment, the first pressure F1 may be greater than the second pressure F2. For example, the first pressure F1 may be about 18 gf, and the second pressure F2 may be about 17 gf.

In an embodiment, since the first pressure F1 is formed to be greater than the second pressure F2, the flexible circuit board 400 may receive a force in the negative Z-axis direction (e.g., a direction toward the circuit board 500 (see FIG. 6)). Since the first pressure F1 is formed to be greater than the second pressure F2, separation of the flexible circuit board 400 in a direction away from the circuit board 500 (see FIG. 6) may be prevented or reduced in a state in which the flexible circuit board 400 is fastened to the connector 300.

In an embodiment, the first contact point 311 and the second contact point 321 may be spaced apart from each other in the width direction of the connector 300 (e.g., the Y-axis direction). For example, the first contact point 311 and the second contact point 321 may be disposed to be spaced apart from each other by a first separation distance E in the width direction of the connector 300 (e.g., the Y-axis direction).

In an embodiment, the first contact point 311 may be located closer to the housing opening 333 of the connector housing 330 than the second contact point 321.

In an embodiment, since the first contact point 311 and the second contact point 321 are spaced apart from each other by the first separation distance E in the width direction of the connector 300 (e.g., the Y-axis direction), and the first contact point 311 is located closer to the housing opening 333 than the second contact point 321, a rotational force Q formed by the first pressure F1 of the first contact point 311 and the second pressure F2 of the second contact point 321 may be transmitted to the flexible circuit board 400. The rotational force Q may prevent or reduce separation of the flexible circuit board 400 in a direction away from the circuit board 500.

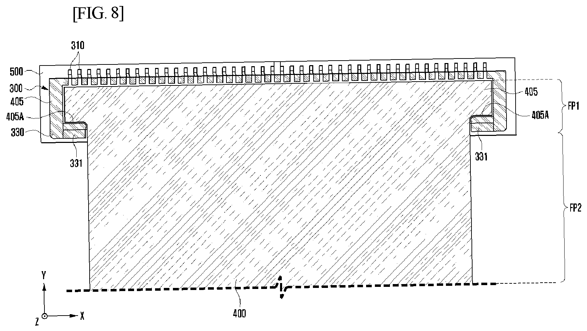

FIG. 8 is a view illustrating a connector 300 and a flexible circuit board 400 according to an embodiment of the disclosure.

FIG. 8 is a view illustrating a state in which the flexible circuit board 400 is fastened to the connector 300 (e.g., the state (603) of FIG. 6). FIG. 8 may be a view illustrating a cross section obtained by cutting the connector 300 in a direction perpendicular to the height direction of the connector 300 (e.g., the Z-axis direction) in a state in which the flexible circuit board 400 is fastened to the connector 300.

Referring to FIG. 8, the flexible circuit board 400 may include an end portion FP1 and/or a flexible portion FP2. In an embodiment, the end portion FP1 of the flexible circuit board 400 may be inserted into the connector 300.

Referring to FIG. 8, in a state in which the flexible circuit board 400 is fastened to the connector 300, the protrusions 405 of the flexible circuit board 400 may overlap the engagement portions 331 of the connector housing 330. For example, protrusions 405 of the flexible circuit board 400 and the engagement portions 331 of the connector housing 330 may be located at substantially the same positions with respect to the length direction of the connector 300 (e.g., the X-axis direction).

Referring to FIG. 8, in a state in which the flexible circuit board 400 is fastened to the connector 300, the flexible circuit board 400 may be disposed such that the contact surfaces 405A of the protrusions 405 face the engagement portions 331 of the connector housing 330.

In an embodiment, in a state in which the flexible circuit board 400 is fastened to the connector 300, the engagement portions 331 of the connector housings 330 may face at least a portion of the flexible circuit board 400 and may prevent or reduce separation of the flexible circuit board 400 from the connector 300.

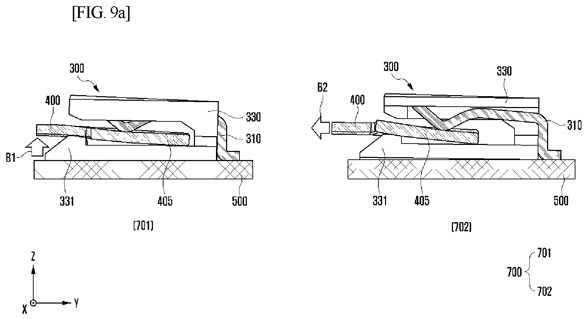

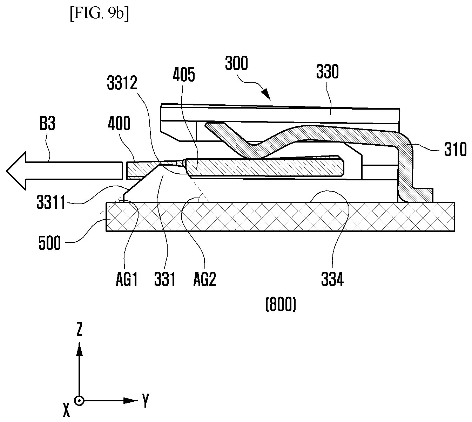

FIGS. 9A and 9B are views respectively illustrating operations of separating the connector 300 and the flexible circuit board 400 according to an embodiment of the disclosure.

FIG. 9A is a view illustrating a first separation operation (700) according to an embodiment. FIG. 9B is a view illustrating a second separation operation (800) according to an embodiment.

In an embodiment, for example, the first separation operation (700) may be an operation of normally separating the flexible circuit board 400 from the connector 300. For example, the first separation operation (700) may be an operation of separating the flexible circuit board 400 without coming into contact with the engagement portion 331 of the connector 300.

In an embodiment, the first separation operation (700) may include a first operation (701) and/or a second operation (702).

In the first operation (701) according to an embodiment, a first separation force B1 may be applied to the flexible circuit board 400. The flexible circuit board 400 may be moved in a direction away from the circuit board 500 by the first separation force B1.

In an embodiment, through the first operation (701), the flexible circuit board 400 may move such that the protrusions 405 do not come into contact with the engagement portions 331.

In an embodiment, as the flexible circuit board 400 moves through the first operation (701), the flexible circuit board 400 may not overlap the engagement portions 331 of the connector housing 330.

In the second operation (702) according to an embodiment, a second separation force B2 may be applied to the flexible circuit board 400. For example, the flexible circuit board 400 may move in a direction away from the connector 300 (e.g., the negative Y-axis direction) by the second separation force B2.

In an embodiment, through the first operation (701), the flexible circuit board 400 moves to a position at which the protrusions 405 do not overlap the engagement portions 331 of the connector housing 330, and thus, in the second operation (702), when the flexible circuit board 400 moves, the flexible circuit board 400 may not come into contact with the engagement portions 331 of the connector housing 330.

In an embodiment, the flexible circuit board 400 may be separated from the connector 300 through the first separation operation (700). In the first separation operation (700), the flexible circuit board 400 does not interfere with the engagement portions 331 of the connector 300, and thus the flexible circuit board 400 and the connector 300 may be easily separated.

In an embodiment, the second separation operation (800) may be an operation of forcibly separating the flexible circuit board 400 from the connector 300. For example, the second separation operation (800) may be an operation of separating the flexible circuit board 400 from the connector 300 in a state in which at least a portion of the flexible circuit board 400 (e.g., the protrusions 405) is in contact with the engagement portions 331 of the connector 300.

In an embodiment, in the second separation operation (800), a third separation force B3 may be applied to the flexible circuit board 400.

In an embodiment, a force applied in the first separation operation (700) may be smaller than a force applied in the second separation operation (800). For example, the first separation force B1 applied in the first operation (701) of the first separation operation (700) may be about 8 N to 10 N. The third separation force B3 applied in the second separation operation (800) may be about 13 N to 15 N.

Referring to FIG. 9B, each of the engagement portions 331 of the connector 300 may be at least partially formed in an asymmetric shape. In an embodiment, the engagement portions 331 may each include a first engagement surface 3311 facing the outside of the connector 300 and/or a second engagement surface 3312 facing the inside of the connector 300.

In an embodiment, the connector housing 330 may include a support surface 334 that is in contact with the circuit board 500.

Referring to FIG. 9B, the first engagement surface 3311 and the support surface 334 of the connector housing 330 may form a first angle AG1. The second engagement surface 3312 and the support surface 334 of the connector housing 330 may form a second angle AG2. The first angle AG1 may be smaller than the second angle AG2. In an embodiment, since the first angle AG1 is smaller than the second angle AG2, insertion of the flexible circuit board 400 into the connector 300 may be easier than separation of the flexible circuit board 400 from the connector 300.

FIG. 10 is a view illustrating movement of a first terminal 310 and a second terminal 320 according to an embodiment of the disclosure.

FIG. 10 may be a view illustrating a state in which an end portion FP1 of the flexible circuit board 400 (see FIG. 8) is separated from the connector 300 or fastened to the connector 300.

A pre-fastening state (1001) of FIG. 10 may indicate the connector 300 before the end portion FP1 of the flexible circuit board 400 (see FIG. 8) is fastened to the connector 300. A post-fastening state (1002) of FIG. 10 may indicate the connector 300 after the end portion FP1 of the flexible circuit board 400 (see FIG. 8) is fastened to the connector 300.

In an embodiment, the first terminal 310 may be disposed such that, in a state in which the end portion FP1 of the flexible circuit board 400 (see FIG. 8) is fastened to the connector 300 (e.g., the post-fastening state (1002)), a first contact point 311 is spaced apart from a circuit board 500 by a first height H1.

In an embodiment, the first terminal 310 may be disposed such that, in a state in which the end portion FP1 of the flexible circuit board 400 (see FIG. 8) is separated from the connector 300 (e.g., the pre-fastening state (1001)), the first contact point 311 is spaced apart from the circuit board 500 by a second height H2 different from the first height H1.

In an embodiment, the second terminal 320 may be disposed such that, in a state in which the end portion FP1 of the flexible circuit board 400 is fastened to the connector 300 (e.g., the post-fastening state (1002)), the second contact point 321 is spaced apart from the circuit board 500 by a third height H3.

In an embodiment, the second terminal 320 may be disposed such that, in a state in which the end portion FP1 of the flexible circuit board 400 (see FIG. 8) is separated from the connector 300 (e.g., the pre-fastening state (1001)), the second contact point 321 is spaced apart from the circuit board 500 by a fourth height H4 different from the third height H3.

In an embodiment, a first difference between the first height H1 and the second height H2 may be greater than a second difference between the third height H3 and the fourth height H4.

In an embodiment, as the flexible circuit board 400 is fastened to the connector 300, at least a portion of the first terminal 310 and at least a portion of the second terminal 320 may move. For example, as the flexible circuit board 400 is inserted into the connector 300, the flexible circuit board 400 may push the first terminal 310 in the positive Z-axis direction and may push the second terminal 320 in the negative Z-axis direction.

Referring to FIG. 10, when the flexible circuit board 400 is fastened to the connector 300, at least a portion of the first terminal 310 may move by a first deformation amount D1. For example, the first contact point 311 of the first terminal 310 may move in the positive Z-axis direction by the first deformation amount D1.

Referring to FIG. 10, when the flexible circuit board 400 is fastened to the connector 300, at least a portion of the second terminal 320 may move by a second deformation amount D2. For example, the second contact point 321 of the second terminal 320 may move in the negative Z-axis direction by the second deformation amount D2.

In an embodiment, the first deformation amount D1 may be greater than the second deformation amount D2. For example, the first deformation amount D1 may be about 0.07 mm, and the second deformation amount D2 may be about 0.06 mm. When the first deformation amount D1 is greater than the second deformation amount D2, the first pressure F1 (see FIG. 7) may be greater than the second pressure F2 (see FIG. 7).

In an embodiment, after the flexible circuit board 400 is fastened to the connector 300, a degree to which the first terminal 310 and/or the second terminal 320 is deformed may be within a predetermined range. For example, after the flexible circuit board 400 is fastened to the connector 300, a degree to which the first terminal 310 and/or the second terminal 320 is deformed in the height direction of the connector 300 (e.g., the Z-axis direction) may be about 20% or less of the first deformation amount D1 or the second deformation amount D2.

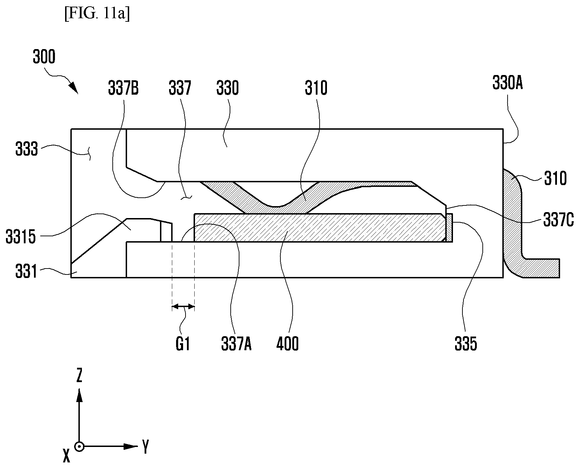

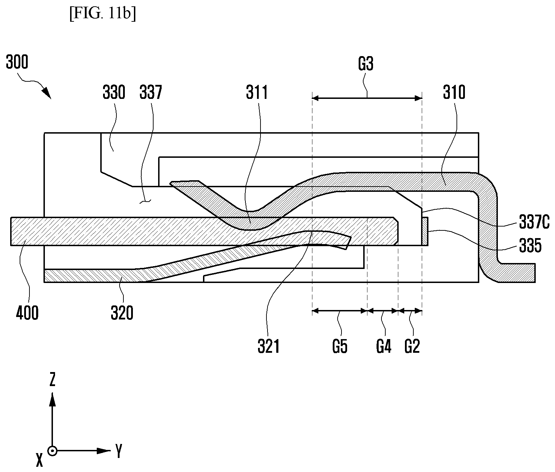

FIGS. 11A and 11B are views illustrating a stopper 335 of a connector 300 according to an embodiment of the disclosure.

FIG. 11A is a view illustrating a state in which a flexible circuit board 400 according to an embodiment is at least partially in contact with the stopper 335. FIG. 11B is a view illustrating a state in which the flexible circuit board 400 according to an embodiment is spaced apart from the stopper 335.

Referring to FIG. 11A, the connector housing 330 may include an engagement portion 331 including a protruding region 3315 protruding from a lower surface 337A of a hollow portion 337 toward an upper surface 337B adjacent to a housing opening 333.

In an embodiment, the lower surface 337A of the hollow portion 337 may be a surface located in the negative Z-axis direction with respect to the hollow portion 337 among surfaces surrounding the hollow portion 337. The upper surface 337B of the hollow portion 337 may be a surface located in the positive Z-axis direction with respect to the hollow portion 337 among the surfaces surrounding the hollow portion 337.

In an embodiment, a sidewall 337C of the hollow portion 337 may be a wall located in the positive Y-axis direction with respect to the hollow portion 337. The sidewall 337C of the hollow portion 337 may face a first sidewall 330A of the connector housing 330.

Referring to FIGS. 11A and 11B, the connector housing 330 may include the stopper 335 in at least a portion thereof.

In an embodiment, the stopper 335 may be formed of a material different from that of the first sidewall 330A of the connector housing 330.

In an embodiment, the stopper 335 may be configured to support the end portion FP1 (see FIG. 8) of the flexible circuit board 400 in a direction toward the housing opening 333 when the end portion FP1 (see FIG. 8) of the flexible circuit board 400 is fastened to the connector 300.

In an embodiment, the stopper 335 may serve to prevent or reduce insertion of the flexible circuit board 400 into the connector 300 beyond a predetermined standard.

In an embodiment, the stopper 335 may include a surface formed substantially perpendicular to a width direction of the connector 300 (e.g., the Y-axis direction). In an embodiment, the stopper 335 may include a surface formed substantially perpendicular to the direction in which the flexible circuit board is inserted (e.g., the Y-axis direction).

Referring to FIG. 11A, when the flexible circuit board 400 is maximally inserted into the connector 300, the flexible circuit board 400 may at least partially come into contact with the stopper 335. When the flexible circuit board 400 is maximally inserted into the connector 300, a protrusion 405 of the flexible circuit board 400 may be spaced apart from the engagement portion 331 of the connector housing 330 by a first distance G1. In an embodiment, the first distance G1 may be about 0.5 mm to 0.15 mm.

In an embodiment, an assembler who fastens the flexible circuit board 400 to the connector 300 may recognize contact between the flexible circuit board 400 and the stopper 335 so as to allow the flexible circuit board 400 to be maximally inserted into the connector 300. That is, the assembler who fastens the flexible circuit board 400 to the connector 300 may insert the flexible circuit board 400 into the connector 300 until the flexible circuit board 400 and the stopper 335 at least partially come into contact with each other, so as to prevent or reduce insufficient insertion of the flexible circuit board 400 into the connector 300.

In an embodiment, the stopper 335 may serve to prevent the flexible circuit board 400 from being inserted into the connector 300 beyond a predetermined standard. For example, when the flexible circuit board 400 is maximally inserted into the connector 300, the flexible circuit board 400 may no longer be inserted into the connector 300 by at least partially coming into contact with the stopper 335. Thus, insertion of the flexible circuit board 400 into the connector 300 beyond the predetermined standard may be prevented or reduced.

FIG. 11B may be a view illustrating a state in which, after the flexible circuit board 400 is fastened to the connector 300, the flexible circuit board 400 is moved to be maximally spaced apart from the stopper 335.

Referring to FIG. 11B, in a state in which the flexible circuit board 400 is fastened to the connector 300, the flexible circuit board 400 may be moved to be spaced apart from the stopper 335 by a second distance G2. In an embodiment, the second distance G2 may be a distance when the flexible circuit board 400 is maximally spaced apart from the stopper 335 in a state in which the flexible circuit board 400 is inserted into the connector 300.

In an embodiment, a third distance G3 may be a distance between the second contact point 321 of the second terminal 320 and the stopper 335. A fourth distance G4 may be a distance from an end of the flexible circuit board 400 to a portion of the flexible circuit board 400 where a pad is formed (e.g., a portion electrically connected to the plating layers 415 and 475 (see FIG. 5)).

In an embodiment, a fifth distance G5 may be a length of a portion in which the flexible circuit board 400 and a terminal (e.g., the second terminal 320) may effectively come into contact with each other. As the fifth distance G5 increases, electrical connection between the second terminal 320 and the flexible circuit board 400 may be facilitated.

In an embodiment, the fifth distance G5 may be calculated based on Equation 1. [Equation 1] $G 5 = G 3 - G 4 - G 2$

In an embodiment, even when the flexible circuit board 400 is maximally spaced apart from the stopper 335 by the second distance G2, the fifth distance G5 may be maintained at a predetermined standard or more, thereby allowing contact and electrical connection between the flexible circuit board 400 and the second terminal 320 to be maintained. For example, in an embodiment, the second distance G2 may be about 0.1 mm. The third distance G3 may be about 0.45 mm. The fourth distance G4 may be about 0.15 mm. In this case, the fifth distance G5 calculated based on Equation 1 may be about 0.20 mm.

In an embodiment, the second contact point 321 of the second terminal 320 may be spaced apart from the sidewall 337C of the hollow portion 337 by the third distance G3. In an embodiment, the third distance G3 may be about 0.40 mm to 0.50 mm.

Referring to FIG. 11B, the first terminal 310 may be disposed in the connector housing 330 such that the second contact point 321 of the second terminal 320 is located between the first contact point 311 of the first terminal 310 and the sidewall 337C of the hollow portion 337.

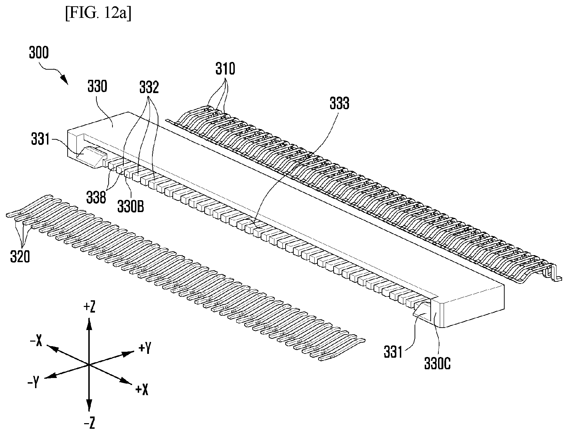

FIGS. 12A and 12B are exploded perspective views of a connector 300 according to an embodiment of the disclosure.

Referring to FIGS. 12A and 12B, the connector 300 may include a first terminal 310, a second terminal 320, and/or a connector housing 330.

Referring to FIGS. 12A and 12B, the connector housing 330 may include an engagement portion 331, a support portion 332, a first opening 336, a second opening 338, and/or a third opening 333.

In an embodiment, the first opening 336 may be formed in a first sidewall 330A of the connector housing 330.

In an embodiment, the first terminal 310 may be inserted into the hollow portion 337 (see FIG. 7) through the first opening 336.

In an embodiment, the second opening 338 may be formed in a second sidewall 330B of the connector housing 330.

In an embodiment, the second terminal 320 may be inserted into the hollow portion 337 (see FIG. 7) through the second opening 338.

In an embodiment, the third opening 333 may refer to the housing opening 333 of FIG. 7.

In an embodiment, the third opening 333 may be formed in a third sidewall 330C of the connector housing 330.

In an embodiment, the connector 300 may include a plurality of second terminals 320. The plurality of second terminals 320 may be inserted into the third opening 333.

In an embodiment, the second terminals 320 may be disposed between two support portions 332. For example, the second terminals 320 may be disposed in a manner of being fitted into the second opening 338 formed between two support portions 332.

In an embodiment, the first terminals 310 may be inserted into the first opening 336.

In an embodiment, the connector 300 may include a plurality of first terminals 310.

In an embodiment, the connector housing 330 may include a plurality of first openings 336.

In an embodiment, the first terminals 310 may be disposed in a manner of being respectively fitted into the plurality of first openings 336.

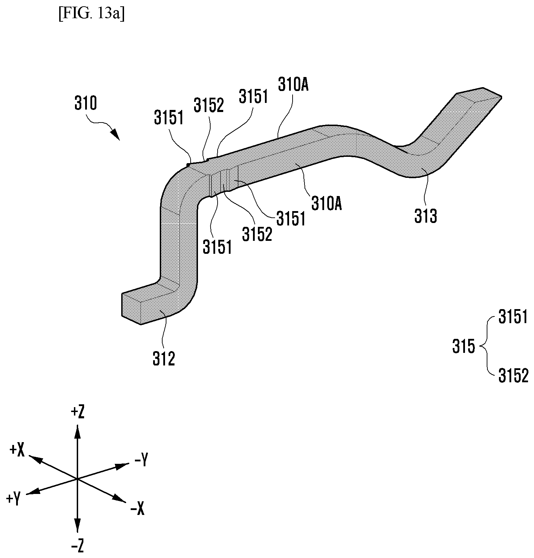

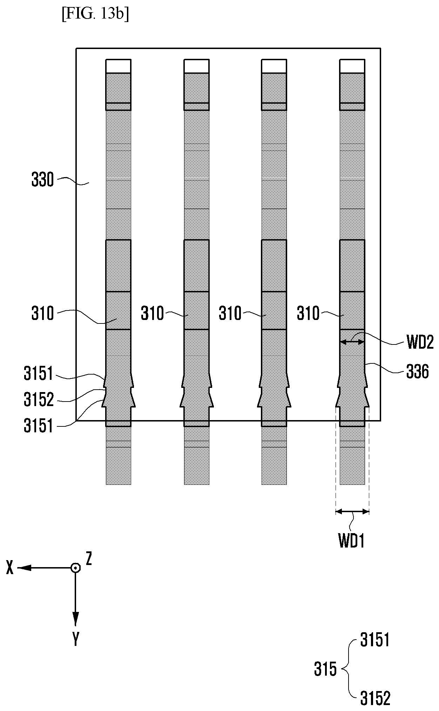

FIGS. 13A and 13B are views illustrating first terminals 310 according to an embodiment of the disclosure.

FIG. 13A is a view illustrating a first terminal 310 according to an embodiment. FIG. 13B is a view illustrating first terminals 310 disposed in a connector housing 330 according to an embodiment.

Referring to FIG. 13A, the first terminal 310 may include a first end portion 312, a first bending region 313, and a first fitting region 315.

In an embodiment, the first terminal 310 may come into contact with a circuit board 500 (see FIG. 6) at the first end portion 312.

In an embodiment, the first terminal 310 may at least partially come into contact with a flexible circuit board 400 (see FIG. 6) at a first contact point 311 of the first bending region 313.

In an embodiment, the first terminal 310 may be fixed to a connector housing 330 in a fitting manner by the first fitting region 315.

In an embodiment, the width of the first fitting region 315 may be a length by which the first fitting region 315 extends in the length direction of the connector housing 330 (e.g., the X-axis direction). Referring to FIG. 13B, the width of the first fitting region 315 may be a first width WD1.

In an embodiment, the width of a first opening 336 may be a length by which the first opening 336 extends in the length direction of the connector housing 330 (e.g., the X-axis direction). Referring to FIG. 13B, the width of the first opening 336 may be a second width WD2.

In an embodiment, the width of the first fitting region 315 may be greater than the width of the first opening 336. For example, the first width WD1 may be greater than the second width WD2 of the first opening 336.

In an embodiment, the first fitting region 315 may include a first protruding region 3151 and/or a first concave region 3152.

In an embodiment, the first protruding region 3151 and the first concave region 3152 may be formed on each of opposite side surfaces 310A of the first terminal 310.

In an embodiment, each of the first protruding regions 3151 may be a region protruding from the side surfaces 310A of the first terminal 310.

In an embodiment, each of the first concave regions 3152 may be a region formed to be concave between two first protruding regions 3151.

Referring to FIG. 13B, the plurality of first terminals 310 may be coupled to the connector housing 330 in a fitted manner.

In an embodiment, the plurality of first terminals 310 may be fixed to the connector housing 330 by the first fitting regions 315. For example, a frictional force between the connector housing 330 and the first terminals 310 may be increased by the first protruding regions 3151 of the first terminals 310, and the first terminals 310 may be more firmly fixed to the connector housing 330.

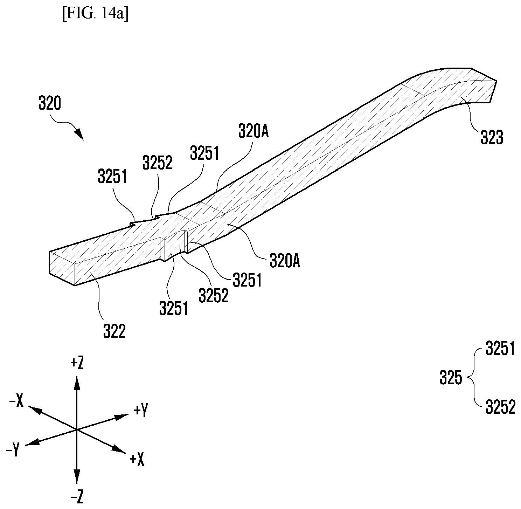

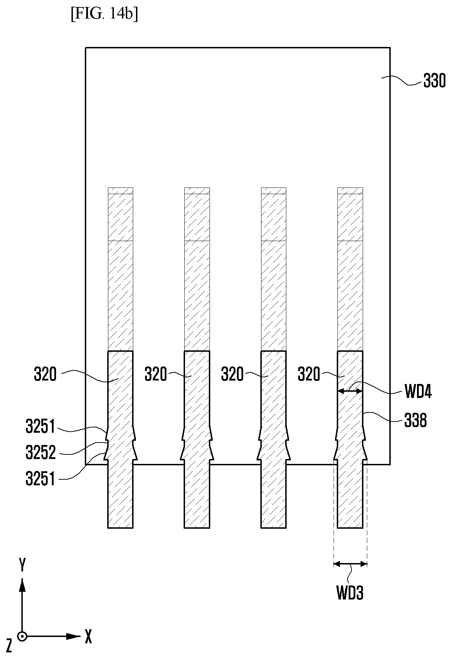

FIGS. 14A and 14B are views illustrating second terminals 320 according to an embodiment of the disclosure.

FIG. 14A is a view illustrating a second terminal 320 according to an embodiment. FIG. 14B is a view illustrating the second terminals 320 disposed in a connector housing 330 according to an embodiment.

Referring to FIG. 14A, the second terminal 320 may include a second end portion 322, a second bending region 323, and a second fitting region 325.

In an embodiment, the second terminal 320 may come into contact with a circuit board 500 (see FIG. 6) at the second end portion 322.

In an embodiment, the second terminal 320 may come into contact with a flexible circuit board 400 (see FIG. 6) at a second contact point 321 of the second bending region 323.

In an embodiment, the second terminal 320 may be fixed to a connector housing 330 in a fitting manner by the second fitting region 325.

In an embodiment, the width of the second fitting region 325 may be a length by which the second fitting region 325 extends in the length direction of the connector housing 330 (e.g., the X-axis direction). Referring to FIG. 14B, the width of the second fitting region 325 may be a third width WD3.

In an embodiment, the width of a second opening 338 may be a length by which the second opening 338 extends in the length direction of the connector housing 330 (e.g., the X-axis direction). Referring to FIG. 14B, the width of the second opening 338 may be a fourth width WD4.

In an embodiment, the width of the second fitting region 325 may be greater than the width of the second opening 338. For example, the third width WD3 may be greater than the fourth width WD4 of the second opening 338.

In an embodiment, the second fitting region 325 may include a second protruding region 3251 and/or a second concave region 3252.

In an embodiment, the second protruding region 3251 and the second concave region 3252 may be formed on each of opposite side surfaces 320A of the second terminal 320.

In an embodiment, each of the second protruding regions 3251 may be a region protruding from the side surfaces 320A of the second terminal 320. In an embodiment, each of the second concave regions 3252 may be a region formed to be concave between two second protruding regions 3251.

Referring to FIG. 14B, the plurality of second terminals 320 may be coupled to the connector housing 330 in a fitted manner.

In an embodiment, the plurality of second terminals 320 may be fixed to the connector housing 330 by the second fitting regions 325. For example, a frictional force between the connector housing 330 and the second terminals 320 may be increased by the second protruding regions 3251 of the second terminals 320, and the second terminals 320 may be more firmly fixed to the connector housing 330.

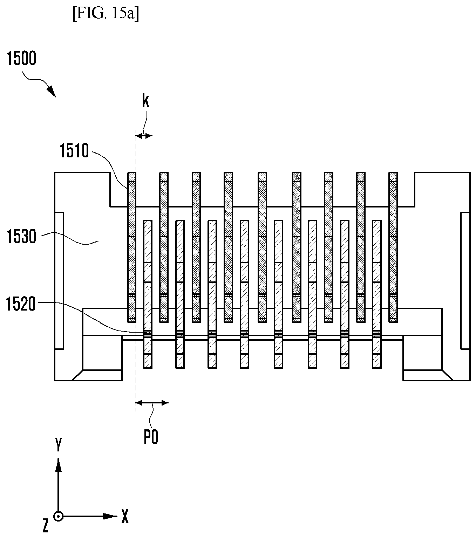

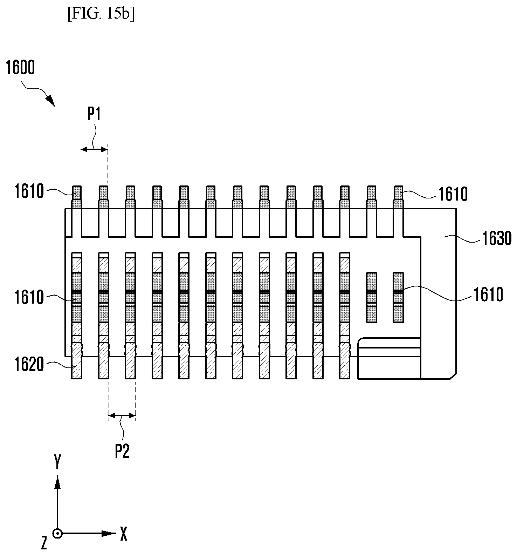

FIGS. 15A and 15B are views illustrating pitches P0, P1, and P2 between first terminals 1510 and 1610.

FIG. 15A is a view illustrating a comparative pitch P0 between first terminals 1510 of a connector 1500 according to a comparative embodiment. FIG. 15B is a view illustrating a first pitch P1 between first terminals 1610 and a second pitch P2 between second terminals 1620 of a connector 1600 according to an embodiment of the disclosure.

In describing the connectors 1500 and 1600 according to an embodiment of the disclosure, the length direction of the connectors 1500 and 1600 may refer to the X-axis direction, and the width direction of the connectors 1500 and 1600 may refer to the Y-axis direction. The height direction of the connectors 1500 and 1600 may refer to the Z-axis direction perpendicular to the length direction and the width direction.

Referring to FIG. 15A, the connector 1500 according to the comparative embodiment may include first terminals 1510, second terminals 1520, and/or a connector housing 1530.

In the comparative embodiment, the plurality of first terminals 1510 may be disposed to be spaced apart from each other in the length direction of the connector 1500 (e.g., the X-axis direction). The plurality of second terminals 1520 may be disposed to be spaced apart from each other in the length direction of the connector 1500 (e.g., the X-axis direction).

In the comparative embodiment, adjacent first and second terminals 1510 and 1520 may be disposed to be spaced apart from each other by a separation distance k in the length direction of the connector 1500 (e.g., the X-axis direction). The separation distance k may be about 0.175 mm.

In the comparative embodiment, a pitch between the plurality of first terminals 1510 may be formed as a comparative pitch P0. The comparative pitch P0 may be twice the separation distance k. The comparative pitch PO may be about 0.35 mm.

In the comparative embodiment, the first terminals 1510 and the second terminals 1520 may not be aligned with each other. The first terminals 1510 and the second terminals 1520 may be disposed at different positions with respect to the length direction of the connector 1500 (e.g., the X-axis direction). For example, in the connector 1500 according to the comparative embodiment, since the first terminals 1510 and the second terminals 1520 need to come into contact with the same surface of a flexible circuit board (e.g., 400, see FIG. 4), the first terminals 1510 and the second terminals 1520 need to be disposed at different positions with respect to the length direction of the connector 1500 (e.g., the X-axis direction). That is, in the connector 1500 according to the comparative embodiment, since the first terminals 1510 and the second terminals 1520 cannot be disposed at overlapping positions, there may be a limitation in reducing the pitch between the terminals 1510 and 1520.

Referring to FIG. 15B, the connector 1600 according to an embodiment of the disclosure may include first terminals 1610, second terminals 1620, and/or a connector housing 1630.

Referring to FIG. 15B, the connector 1600 according to an embodiment may include first terminals 1610, second terminals 1620, and/or a connector housing 1630.

In an embodiment, the plurality of first terminals 1610 may be disposed to be spaced apart from each other in the length direction of the connector 1600 (e.g., the X-axis direction). The plurality of second terminals 1620 may be disposed to be spaced apart from each other in the length direction of the connector 1600 (e.g., the X-axis direction).

In an embodiment, a pitch between the plurality of first terminals 1610 may be formed as a first pitch P1. The first pitch P1 may be about 0.30 mm or less. The first pitch P1 may be smaller than the comparative pitch P0.

In an embodiment, a pitch between the plurality of second terminals 1620 may be formed as a second pitch P2. The second pitch P2 may be about 0.30 mm or less. The second pitch P2 may be smaller than the comparative pitch P0.

In an embodiment, the first terminals 1610 and the second terminals 1620 may be disposed to be aligned with each other. The first terminals 1610 and the second terminals 1620 may be disposed at substantially the same positions with respect to the length direction of the connector 1600 (e.g., the X-axis direction). For example, in the connector 1600 according to an embodiment of the disclosure, since the first terminals 1610 and the second terminals 1620 may come into contact with different surfaces of a flexible circuit board (see, e.g., 400 of FIG. 4), the first terminals 1610 and the second terminals 1620 may be disposed at positions aligned with each other with respect to the length direction of the connector 1500 (e.g., the X-axis direction).

In the connector 1600 according to an embodiment of the disclosure, the first terminals 1610 and the second terminals 1620 may come into contact with different surfaces of the flexible circuit board 400 (see FIG. 6). That is, in the connector 1600 according to an embodiment, the first terminals 1610 may come into contact with a first surface 400A (see FIG. 6) of the flexible circuit board 400 (see FIG. 6), and the second terminals 1620 may come into contact with a second surface 400B (see FIG. 6) of the flexible circuit board 400 (see FIG. 6). In the connector 1600 according to an embodiment of the disclosure, since the terminals 1610 and 1620 come into contact with both surfaces 400A and 400B (see FIG. 6) of the flexible circuit board 400 (see FIG. 6), a pitch P2 between the terminals 1610 and 1620 may be reduced compared to the connector 1500 according to the comparative embodiment.

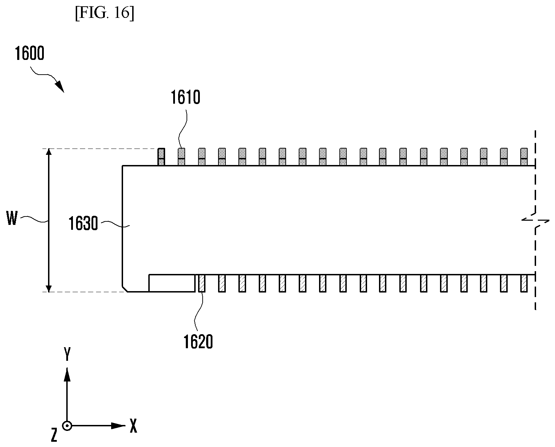

FIG. 16 is a view illustrating a connector 1600 according to an embodiment of the disclosure.

The connector 1600 according to an embodiment of the disclosure may include first terminals 1610, second terminals 1620, and/or a connector housing 1630.

The connector 1600 according to an embodiment of the disclosure may have a first width W in the width direction of the connector 1600 (e.g., the Y-axis direction). For example, a distance from an end of the first terminal 1610 to the second terminals 1620 in the width direction of the connector 1600 (e.g., the Y-axis direction) may be the first width W.

Since the connector 1600 according to an embodiment of the disclosure does not require a separate device (not illustrated) for coupling a flexible circuit board 400 (see FIG. 6) and the connector 1600, the length of the connector 1600 in the width direction (e.g., the Y-axis direction) may be reduced. For example, when a separate device (not illustrated) for coupling a flexible circuit board 400 (see FIG. 6) and the connector 1600 is required, the length of the connector 1600 in the width direction (e.g., the Y-axis direction) corresponding to the first width W may be about 3.2 mm. However, since the connector 1600 according to an embodiment of the disclosure does not require a separate device (not illustrated), the first width W may be about 2.3 mm.

Since the connector 1600 according to an embodiment of the disclosure does not require a separate device (not illustrated) for coupling the flexible circuit board 400 (see FIG. 6) and the connector 1600, cost and time required to manufacture the separate device (not illustrated) may be reduced.

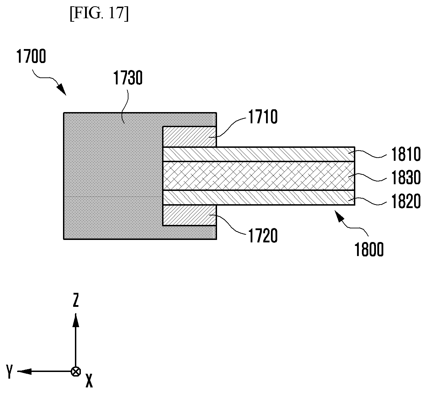

FIG. 17 is a view illustrating a connector 1700 and a flexible circuit board 1800 according to an embodiment of the disclosure.

The connector 1700 of FIG. 17 may refer to the connector 300 of FIG. 3A or may include at least a portion of the connector 300.

The flexible circuit board 1800 of FIG. 17 may refer to the flexible circuit board 400 of FIG. 4 or may include at least a portion of the flexible circuit board 400.

In an embodiment, the connector 1700 may include a first terminal 1710, a second terminal 1720, and/or a connector housing 1730.

In an embodiment, the flexible circuit board 1800 may include a first layer 1810, a second layer 1820, and/or a third layer 1830.

In an embodiment, the first layer 1810 and the second layer 1820 may include a conductive material. The third layer 1830 may be a layer including an insulating material.

In an embodiment, the first layer 1810 may be disposed on one surface of the third layer 1830 (e.g., a surface of the third layer 1830 oriented in the positive Z-axis direction). The second layer 1820 may be disposed on the other surface of the third layer 1830 (e.g., a surface of the third layer 1830 oriented in the negative Z-axis direction).

In an embodiment, the first terminal 1710 of the connector 1700 may at least partially come into contact with the first layer 1810 of the flexible circuit board 1800. The second terminal 1720 of the connector 1700 may at least partially come into contact with the second layer 1820 of the flexible circuit board 1800.

In the flexible circuit board 1800 according to an embodiment of the disclosure, the first terminal 1710 of the connector 1700 may at least partially come into contact with and be electrically connected to a pad formed on the first layer 1810, and the second terminal 1720 of the connector 1700 may at least partially come into contact with and be electrically connected to a pad formed on the second layer 1820. Thus, a via for electrically connecting the first layer 1810 and the second layer 1820 may not be required. That is, the circuit board 1800 according to an embodiment of the disclosure may not require a via because the flexible circuit board 1800 comes into contact with the first terminal 1710 or the second terminal 1720 of the connector 1700 on each of opposite surfaces thereof. In the flexible circuit board 1800 according to an embodiment of the disclosure, since the number of vias for electrically connecting the first layer 1810 and the second layer 1820 is reduced, cost and time required to manufacture vias may be reduced.

In the flexible circuit board 1800 according to an embodiment of the disclosure, since the first layer 1810 and the second layer 1820 come into contact with the terminals 1710 and 1720 of the connector 1700, a pitch between pads (not illustrated) formed on the flexible circuit board 1800 may be relatively increased. That is, the flexible circuit board 1800 may be advantageous in increasing a pitch between pads (not illustrated) formed on the flexible circuit board 1800 compared to a case in which the flexible circuit board 1800 comes into contact with a connector on one surface.

When terminals of a connector come into contact only with one surface of a flexible circuit board, the flexible circuit board may need to include vias for electrically connecting at least some of the terminals of the connector to the other surface opposite to the one surface of the flexible circuit board. When the flexible circuit board needs to include vias, manufacturing cost and time may be additionally required to form the vias.

When the flexible circuit board does not include vias, a connector having a form in which terminals of the connector come into contact only with one surface of the flexible circuit board may have difficulty in reducing a pitch between the terminals, and thus an overall size of the connector may increase.

An electronic device 101 or 200 according to an embodiment of the disclosure may include a flexible circuit board 240 or 400, a circuit board 220 or 500, and a connector 250 or 300 disposed on the circuit board 220 or 500 and configured to be fastened to or separated from an end portion FP1 of the flexible circuit board 240 or 400. The connector 250 or 300 may include a connector housing 330 including a hollow portion 337 formed therein, a first terminal 310 extending from the circuit board 500 to the hollow portion 337 and configured to apply a first pressure F1 in a first direction via a first contact point 311 thereof, and a second terminal 320 extending from the circuit board 500 to the hollow portion 337 and configured to apply a second pressure F2 in a second direction opposite to the first direction via a second contact point 321 thereof. The first terminal 310 and the second terminal 320 may be configured such that, when the end portion FP1 of the flexible circuit board is fastened to the connector, the first contact point 311 and the second contact point 321 come into contact with a first surface 400A and a second surface 400B of the end portion FP1, respectively.

In an embodiment, the flexible circuit board 240 or 400 may include a first insulating cover layer 410 forming a portion of the first surface 400A and including a first opening region 411 formed therein, a second insulating cover layer 470 forming a portion of the second surface 400B and including a second opening region 471 formed therein, a first conductive layer 420 disposed under the first insulating cover layer 410, and a second conductive layer 460 disposed on the second insulating cover layer 470. The flexible circuit board 400 may be configured to electrically connect the first conductive layer 420 to the first contact point 311 through the first opening region 411 and electrically connect the second conductive layer 460 to the second contact point 321 through the second opening region 471 when the flexible circuit board 400 is fastened to the connector 300.

In an embodiment, the end portion FP1 of the flexible circuit board 400 may include a first plating layer 415 disposed on the first conductive layer 420 and filling at least a portion of the first opening region 411, or a second plating layer 475 disposed under the second conductive layer 460 and filling at least a portion of the second opening region 471.

In an embodiment, the end portion FP1 of the flexible circuit board 400 may include an insulating adhesive layer 440 between the first conductive layer 420 and the second conductive layer 460, and the insulating adhesive layer 440 may have a thickness greater than that of each of the first conductive layer 420 and the second conductive layer 460.

In an embodiment, the first terminal 310 and the second terminal 320 may be formed such that the first pressure F1 is greater than the second pressure F2.

In an embodiment, the first terminal 310 may include a first bending region 313 bent convexly in the first direction and including the first contact point 311, and the second terminal 320 may include a second bending region 323 bent convexly in the second direction and including the second contact point 321.

In an embodiment, a first length BL1 of the first bending region 313 may be greater than a second length BL2 of the second bending region 323.

In an embodiment, a first bending radius BR1 of the first bending region 313 may be smaller than a second bending radius BR2 of the second bending region 323.

In an embodiment, the first terminal 310 may be disposed such that, when the end portion FP1 is fastened to the connector 300, the first contact point 311 is spaced apart from the circuit board 500 by a first height H1. The first terminal 310 may be disposed such that, when the end portion FP1 is separated from the connector 300, the first contact point is spaced apart from the circuit board 500 by a second height H2 different from the first height H1. The second terminal 320 may be disposed such that, when the end portion FP1 is fastened to the connector 300, the second contact point 321 is spaced apart from the circuit board 500 by a third height H3. The second terminal 320 may be disposed such that, when the end portion FP1 is separated from the connector 300, the second contact point 321 is spaced apart from the circuit board 500 by a fourth height H4, and a first difference between the first height H1 and the second height H2 may be greater than a second difference between the third height H3 and the fourth height H4.

In an embodiment, the first terminal 310 and the second terminal 320 may include a plurality of first terminals 310 and a plurality of second terminals 320, respectively, arranged in a length direction of the connector housing 330, and at least one terminal among the plurality of second terminals 320 may be aligned with a corresponding terminal among the plurality of first terminals 310.

In an embodiment, a first pitch P1 between the plurality of first terminals 310 and a second pitch P2 between the plurality of second terminals 320 may each be 0.30 mm or less.

In an embodiment, the connector housing 330 may include a first opening 336 formed in a first sidewall 330A, a second opening 338 formed in a second sidewall 330B opposite to the first sidewall 330A, and a third opening 333. The first terminal 310 may be inserted into the hollow portion 337 through the first opening 336, the second terminal 320 may be inserted into the hollow portion 337 through the second opening 338, and the end portion FP1 may be inserted into the hollow portion 337 through the third opening 333.

In an embodiment, the first contact point 311 may be located closer to the third opening 333 than the second contact point 321.

In an embodiment, at least one terminal of the first terminal 310 or the second terminal 320 may include a fitting region 315 or 325 having a width greater than a width of a corresponding one of the first opening 336 and the second opening 338, and the fitting region 315 or 325 of the at least one terminal may be fitted into the corresponding opening.

In an embodiment, the connector housing 330 may include an engagement portion 331 including a protruding region 3315 protruding from a lower surface of the hollow portion 337 toward an upper surface thereof adjacent to an entrance of the third opening 333.

In an embodiment, the connector housing 330 may include a stopper 335 disposed on a sidewall 337C of the hollow portion 337 facing the first sidewall 330A and formed of a material different from that of the first sidewall 330A.

In an embodiment, the stopper 335 may be configured to support the end portion FP1 in a direction toward the third opening 333 when the end portion FP1 is fastened to the connector 300.

In an embodiment, the first terminal 310 may be disposed in the connector housing 330 such that the second contact point 321 is located between the first contact point 311 and the sidewall 337C of the hollow portion 337.

In an embodiment, the second contact point 321 may be spaced apart from the sidewall 337C of the hollow portion 337 by 0.40 mm to 0.50 mm.

In an embodiment, the electronic device 101 or 200 may include an additional circuit board (e.g., the second circuit board 230 of FIG. 2) including at least one component disposed therein. The at least one component includes an antenna (e.g., the antenna module 197 of FIG. 1), a microphone (e.g., the input module 150 of FIG. 1), a speaker (e.g., the sound output module 155 of FIG. 1), or a haptic module (e.g., the haptic module 179 of FIG. 1).

In an embodiment, the circuit board 220 may include a processor (e.g., the processor 120 of FIG. 1) disposed therein.

In an embodiment, the connector 250 or 300 may be configured to connect the circuit board 220 and the additional circuit board 230 via the flexible circuit board 240.

The electronic device 101 or 200 according to an embodiment of the disclosure may include the circuit board 220, the flexible circuit board 240 or 400, and the connector 250 or 300.

In an embodiment, the flexible circuit board 240 may be electrically connected to the circuit board 220.

In an embodiment, the connector 250 or 300 may be disposed on the circuit board 220 and may be coupled to the flexible circuit board 240.

In an embodiment, the connector 300 may include a plurality of first terminals 310, a plurality of second terminals 320, and the connector housing 330.

In an embodiment, the plurality of first terminals 310 may be disposed to be spaced apart from each other in the length direction of the connector 300 and may include first contact points 311.

In an embodiment, the plurality of second terminals 320 may be disposed to be aligned with the plurality of first terminals 310, may at least partially face the plurality of first terminals 310, and may include second contact points 321.

In an embodiment, the plurality of first terminals 310 and the plurality of second terminals 320 may be disposed in the connector housing 330.

In an embodiment, the first contact points 311 may come into contact with a portion of the first surface 400A of the flexible circuit board 400, and the second contact points 321 may come into contact with a portion of the second surface 400B opposite to the first surface 400A of the flexible circuit board 400.

In the connector 300 according to an embodiment of the disclosure, since the terminals 310 and 320 come into contact with both surfaces 400A and 400B of the flexible circuit board 400, a pitch P2 between the terminals 410 and 420 may be reduced compared to the connector 1500 according to a comparative embodiment.

In the connector 300 according to an embodiment of the disclosure, since the terminals 310 and 320 of the connector 300 may come into contact with both surfaces 400A and 400B of the flexible circuit board 400, the number of vias of the flexible circuit board 400 may be reduced.

The connector 300 according to an embodiment of the disclosure may be configured such that the terminals 310 and 320 of the connector 300 come into contact with both surfaces 400A and 400B of the flexible circuit board 400, so that the size of the connector 300 may be reduced.

In an embodiment, the second surface 400B of the flexible circuit board 400 may be disposed such that at least a portion thereof faces a first circuit board 500.

In an embodiment, a first pressure F1 directed toward the flexible circuit board 400 at the first contact point 311 may be greater than a second pressure F2 directed toward the flexible circuit board 400 at the second contact point 321.

In an embodiment, since the first pressure F1 is formed to be greater than the second pressure F2, separation of the flexible circuit board 400 in a direction away from the circuit board 500 may be prevented or reduced in a state in which the flexible circuit board 400 is fastened to the connector 300.

In an embodiment, the first terminal 310 may include a first bending region 313 bent convexly in a direction toward the flexible circuit board 400 (e.g., the first direction).

In an embodiment, the second terminal 320 may include a second bending region 323 bent convexly in a direction toward the flexible circuit board 400 (e.g., the second direction).

In an embodiment, the first contact point 311 may be formed in the first bending region 313, and the second contact point 321 may be formed in the second bending region 323.

In an embodiment, the connector housing 330 may include engagement portions 331 located at opposite ends of the connector housing 330 with respect to the length direction of the connector 300 and formed to protrude in the height direction of the connector 300.

In an embodiment, in a state in which the flexible circuit board 400 is fastened to the connector 300, the engagement portions 331 of the connector housings 330 may face at least a portion of the flexible circuit board 400 and may prevent or reduce separation of the flexible circuit board 400 from the connector 300.

In an embodiment, the flexible circuit board 400 may include protrusions 405 formed at opposite ends of the flexible circuit board 400 so as to face the engagement portions 331.

In an embodiment, the connector housing 330 may include a stopper 335 configured to prevent the flexible circuit board 400 from being inserted into the connector 300 to a predetermined length or more.

In an embodiment, the stopper 335 may include a surface formed perpendicular to the width direction of the connector 300.

In an embodiment, the stopper 335 may serve to prevent or reduce insertion of the flexible circuit board 400 into the connector 300 beyond a predetermined standard.

In an embodiment, the connector housing 330 may include an opening 333 into which the flexible circuit board is inserted.

In an embodiment, the first contact point 311 and the second contact point 321 may be spaced apart from each other in the width direction of the connector 300, and the first contact point 311 may be located closer to the opening 333 of the connector housing 330 into which the flexible circuit board 400 is inserted than the second contact point 321.

In an embodiment, the plurality of first terminals 310 and the plurality of second terminals 320 may be coupled to at least a portion of the connector housing 330 in a fitted manner.

In an embodiment, each of the plurality of first terminals 310 may include a fitting region 315.

In an embodiment, the fitting region 315 may include two protruding regions 3151 formed on at least a portion of a side surface 310A of the first terminal 310 and a concave region 3152 located between the two protruding regions 3151 and formed by a portion of the side surface 310A of the first terminal 310 having a concave shape.

In an embodiment, the plurality of terminals 310 and 320 may be more firmly fixed to the connector housing 330 through the fitting regions 315 and 325.

In an embodiment, the electronic device may include a second circuit board 230 disposed to be spaced apart from the first circuit board 220.

In an embodiment, the flexible circuit board 240 may electrically connect the first circuit board 220 and the second circuit board 230.

In an embodiment, a first thickness t1 of the first terminal 310 may be greater than a second thickness t2 of the second terminal 320.

In an embodiment, the connector housing 330 may include a support surface 334 that is in contact with the first circuit board 500.

In an embodiment, the engagement portion 331 may include a first engagement surface 3311 facing the outside of the connector 300 and a second engagement surface 3312 facing the inside of the connector 300.

In an embodiment, a first angle AG1 formed by the first engagement surface 3311 and the support surface 334 of the connector housing 330 may be smaller than a second angle AG2 formed by the second engagement surface 3312 and the support surface 334 of the connector housing 330.

In an embodiment, since the first angle AG1 is smaller than the second angle AG2, insertion of the flexible circuit board 400 into the connector 300 may be easier than separation of the flexible circuit board 400 from the connector 300.

The technical subjects pursued in the disclosure may not be limited to the above-mentioned technical subjects, and other technical subjects which are not mentioned herein may be clearly understood from the following description by those skilled in the art to which the disclosure pertains.

Advantageous effects obtainable from the disclosure are not limited to the effects mentioned above, and other effects not mentioned herein will be clearly understood by those skilled in the art to which the disclosure belongs.

An electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, or a home appliance. The electronic device according to an embodiment of the disclosure is not limited to those described above.

It should be appreciated that an embodiment of the disclosure and the terms used therein are not intended to limit the technological features set forth herein to particular embodiments and the disclosure includes various changes, equivalents, or alternatives for a corresponding embodiment. In relation to the description of the drawings, similar reference numerals may be used for similar or related components. The singular form of a noun corresponding to an item may include one item or a plurality of items unless the context clearly indicates otherwise. As used herein, each of such phrases as "A or B," "at least one of A and B," "at least one of A or B," "A, B, or C," at least one of A, B, and C,"and "at least one of A, B, or C," may include all possible combinations of the items enumerated together in a corresponding one of the phrases. Such terms as "a first", "a second", "the first", and "the second" may be used to simply distinguish a corresponding element from another, and does not limit the elements in other aspect (e.g., importance or order). When a certain (e.g., a first) component is mentioned as being "coupled" or "connected" to another (e.g., a second) component, with or without a term "functionally" or "communicatively," it means that the certain component may be connected to the other component directly (e.g., wiredly), wirelessly, or via a third component.

As used in an embodiment of the disclosure, the term "module" may include a unit implemented in hardware, software, or firmware, and may be interchangeably used with other terms, for example, "logic," "logic block," "component," or "circuit". The module may be an integrally configured component or a minimum unit or a portion of the component, which performs one or more functions. For example, according to an embodiment, the module may be implemented in the form of an application-specific integrated circuit (ASIC).

An embodiment of the disclosure may be implemented as software (e.g., the program 101) including one or more instructions that are stored in a storage medium (e.g., the internal memory 136 or external memory 138) that is readable by a machine (e.g., the electronic device 140). For example, a processor (e.g., the processor 120) of a device (e.g., the electronic device 101) may invoke and execute at least one of the stored one or more instructions from the storage medium. This enables the device to be operated to perform at least one function in response to the at least one invoked instruction. The one or more instructions may include codes generated by a compiler or code capable of being executed by an interpreter. The machine-readable storage medium may be provided in the form of a non-transitory storage medium. Here, the term "non-transitory" merely means that the storage medium is a tangible device and does not contain a signal (e.g., electromagnetic waves), and this term is not intended to distinguish a case where data is permanently stored on the storage medium and a case where data is temporarily stored.

According to an embodiment, a method according to various embodiments of the disclosure may be included and provided in a computer program product. The computer program product may be traded as a product between a seller and a purchaser. The computer program product may be distributed in the form of a machine-readable storage medium (e.g., a compact disc read-only memory (CD-ROM)), or may be directly distributed through an application store (e.g., Play Store^{™}) or directly between two user devices (e.g., smartphones), or may be distributed online (e.g., downloaded or uploaded). If distributed online, at least part of the computer program product may be temporarily stored or produced in a machine-readable storage medium such as a manufacturer's server, a server of an application store, or the memory of a relay server.

According to an embodiment, each component (e.g., a module or a program) of the above-described components may include a single entity or multiple entities, and some of the multiple entities may be separately disposed in different components. According to various embodiments, one or more of the components or operations described above may be omitted, or one or more other components or operations may be added. Alternatively, or additionally, multiple components (e.g., modules or programs) may be integrated into a single component. In such a case, the integrated element may perform one or more functions of each of the plurality of elements in the same or similar manner as they are performed by a corresponding one of the plurality of elements before the integration.

According to an embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device (101, 200) comprising:
a flexible circuit board (240, 400);
a circuit board (220, 500); and
a connector (250, 300) disposed on the circuit board (220, 500) and configured to be fastened to or separated from the flexible circuit board (240, 400),
wherein the connector comprises:
a connector housing (330) including a hollow portion (337),
a first terminal (310) extending from the circuit board to the hollow portion and configured to apply a first pressure (F1) in a first direction via a first contact point (311), and
a second terminal (320) extending from the circuit board to the hollow portion and configured to apply a second pressure (F2) in a second direction opposite to the first direction via a second contact point (321), and
wherein the first terminal and the second terminal are configured such that, when the flexible circuit board is fastened to the connector, the first contact point and the second contact point come into contact with a first surface (400A) and a second surface (400B) of the flexible circuit board, respectively.

2. The electronic device of claim 1, wherein the flexible circuit board comprises:
a first insulating cover layer (410) forming a part of the first surface and including a first opening area (411);
a second insulating cover layer (470) forming a part of the second surface and including a second opening area (471);
a first conductive layer (420) disposed under the first insulating cover layer; and
a second conductive layer (460) disposed on the second insulating cover layer, and
wherein, when the flexible circuit board is fastened to the connector, the flexible circuit board is configured to electrically connect the first conductive layer to the first contact point through the first opening area and electrically connect the second conductive layer to the second contact point through the second opening area.

3. The electronic device of claim 2, wherein the flexible circuit board comprises a first plating layer (415) disposed on the first conductive layer and filling at least a portion of the first opening area, or a second plating layer (475) disposed under the second conductive layer and filling at least a portion of the second opening area.

4. The electronic device of claim 2, wherein the flexible circuit board comprises an insulating adhesive layer (440) between the first conductive layer and the second conductive layer, and the insulating adhesive layer has a thickness greater than a thickness of each of the first conductive layer and the second conductive layer.

5. The electronic device of claim 1, wherein the first terminal comprises a first bending region (313) bent convexly in the first direction and including the first contact point, and
wherein the second terminal comprises a second bending region (323) bent convexly in the second direction and including the second contact point.

6. The electronic device of claim 5, wherein a first length (BL1) of the first bending region is greater than a second length (BL2) of the second bending region, and
wherein a first bending radius (BR1) of the first bending region is smaller than a second bending radius (BR2) of the second bending region.

7. The electronic device of claim 1, wherein the first terminal is disposed such that, when the flexible circuit board is fastened to the connector, the first contact point is spaced apart from the circuit board by a first height (H1),
wherein the first terminal is disposed such that, when the flexible circuit board is separated from the connector, the first contact point is spaced apart from the circuit board by a second height (H2) different from the first height,
wherein the second terminal is disposed such that, when the flexible circuit board is fastened to the connector, the second contact point is spaced apart from the circuit board by a third height (H3),
wherein the second terminal is disposed such that, when the flexible circuit board is separated from the connector, the second contact point is spaced apart from the circuit board by a fourth height (H4) different from the third height, and
wherein a first difference between the first height and the second height is greater than a second difference between the third height and the fourth height.

8. The electronic device of claim 1, wherein the first terminal and the second terminal comprise a plurality of first terminals and a plurality of second terminals, respectively, arranged in a length direction of the connector housing, and
wherein at least one terminal among the plurality of second terminals is aligned with a corresponding terminal among the plurality of first terminals.

9. The electronic device of claim 1, wherein the connector housing comprises a first opening (336) formed in a first sidewall (330A), a second opening (338) formed in a second sidewall (330B) opposite to the first sidewall, and a third opening (333),
wherein the first terminal is inserted into the hollow portion through the first opening,
wherein the second terminal is inserted into the hollow portion through the second opening, and
wherein the flexible circuit board is inserted into the hollow portion through the third opening.

10. The electronic device of claim 9, wherein the first contact point is located closer to the third opening than the second contact point.

11. The electronic device of claim 9, wherein at least one terminal of the first terminal or the second terminal comprises a fitting region (315, 325) having a width greater than a width of a corresponding one of the first opening and the second opening, and
wherein the fitting region of the at least one terminal is fitted into the corresponding opening.

12. The electronic device of claim 9, wherein the connector housing further comprises an engagement portion (331) including a protruding region (3315), adjacent to an entrance of the third opening, protruding from a lower surface of the hollow portion toward an upper surface of the hollow portion.

13. The electronic device of claim 9, wherein the connector housing further comprises a stopper (335) disposed on a sidewall of the hollow portion facing the first sidewall and formed of a material different from a material of the first sidewall, and the stopper is configured to support the flexible circuit board in a direction toward the third opening when the flexible circuit board is fastened to the connector.

14. The electronic device of claim 1, wherein the first terminal is disposed in the connector housing such that the second contact point is located between the first contact point and a sidewall of the hollow portion, and
wherein the second contact point is disposed to be spaced apart from the sidewall of the hollow portion.

15. The electronic device of claim 1, wherein the electronic device further comprises an additional circuit board comprising at least one component among an antenna, a microphone, a speaker, or a haptic module,
wherein the circuit board comprises a processor, and
wherein the connector is configured to connect the circuit board and the additional circuit board via the flexible circuit board.
